# EUROPEAN PATENT APPLICATION

(11) **EP 4 804 407 A1**
(43) Date of publication of application: **09.09.2026**
(21) Application number: 26162606.3
(22) Date of filing: 05.03.2026
(51) Int. Cl.: H03L 7/08, H03L 7/087, H03L 7/089, H03L 7/093, H03L 7/099, H03L 7/107

(54) **SYNCHRONIZING CIRCUIT AND COMMUNICATION INTERFACE CIRCUIT**

(30) Priority: 07.03.2025 JP 2025035971
(71) Applicant: Seiko Epson Corporation, Tokyo 160-8801 (JP)
(72) Inventor: KITAZAWA, Takayuki, Suwa-shi, Nagano, 392-8502 (JP)
(74) Representative: MERH-IP Matias Erny Reichl Hoffmann Patentanwälte PartG mbB

(57) **Abstract**

A frequency locked loop includes a frequency phase comparator, a loop filter, and a voltage-controlled oscillator, and performs frequency synchronization between a predetermined clock signal and an input signal. A phase locked loop includes a phase comparator, the loop filter, and the voltage-controlled oscillator, and performs phase synchronization between the predetermined clock signal and the input signal. When the frequency locked loop is selected by a switch circuit, the loop filter performs the first loop filter processing as the loop filter processing of first filter characteristics. When the phase locked loop is selected by the switch circuit, the loop filter performs the second loop filter processing as the loop filter processing of second filter characteristics different from the first filter characteristics.

## Description

The present application is based on, and claims priority from JP Application Serial Number 2025-035971, filed March 7, 2025, the disclosure of which is hereby incorporated by reference herein in its entirety.

### BACKGROUND

### 1. Technical Field

The present disclosure relates to a synchronizing circuit, a communication interface circuit, and the like.

### 2. Related Art

In the related art, in an embedded clock method in which a clock signal for synchronization is superimposed on a data signal line and transmitted, a technique of synchronizing a clock signal generated at a transmission side with a clock signal generated at a reception side using a PLL circuit or the like is known. JP-A-2012-044446 discloses a technique of using the same loop filter for a frequency loop for locking a clock frequency at a reception side to a desired rate and a phase loop for phase synchronization between a locked clock signal and a data signal.

JP-A-2012-044446 is an example of the related art.

The comparison frequencies are not necessarily the same between the frequency loop and the phase loop. JP-A-2012-044446 does not propose a technique related to a loop filter for filter processing respectively suitable for a high-frequency loop and a phase loop.

### SUMMARY

An aspect of the present disclosure relates to a synchronizing circuit including a voltage-controlled oscillator that generates a predetermined clock signal as a clock signal having a frequency corresponding to a control voltage of a control voltage node, a loop filter coupled to the control voltage node, and a switch circuit that switches between a frequency locked loop and a phase locked loop, wherein the frequency locked loop includes a frequency phase comparator, the loop filter, and the voltage-controlled oscillator, and performs frequency synchronization between the predetermined clock signal and an input signal, the phase locked loop includes a phase comparator, the loop filter, and the voltage-controlled oscillator, and performs phase synchronization between the predetermined clock signal and the input signal, and the loop filter performs the first loop filter processing as the loop filter processing of first filter characteristics when the frequency locked loop is selected by the switch circuit, and performs the second loop filter processing as the loop filter processing of second filter characteristics different from the first filter characteristics when the phase locked loop is selected by the switch circuit.

Another aspect of the present disclosure relates to a communication interface circuit including the synchronizing circuit described above.

### BRIEF DESCRIPTION OF THE DRAWINGS

FIG. 1 shows a configuration example of a communication interface circuit.
FIG. 2 shows a configuration example of a synchronizing circuit.
FIG. 3 shows a configuration example of a frequency-locked loop.
FIG. 4 shows a configuration example of a first charge pump circuit.
FIG. 5 shows a configuration example of a phase-locked loop.
FIG. 6 shows examples of a first switch circuit and a second switch circuit.
FIG. 7 shows another configuration example of the synchronizing circuit.
FIG. 8 shows another configuration example of the synchronizing circuit.
FIG. 9 shows a configuration example of a loop filter.
FIG. 10 shows a configuration example of a resistance selection circuit.
FIG. 11 shows another configuration example of the resistance selection circuit.
FIG. 12 shows an operation example of a control circuit.
FIG. 13 shows an example of a voltage-controlled oscillator.
FIG. 14 conceptually illustrates a relationship between frequency lock and phase lock.
FIG. 15 conceptually illustrates an example of a phase comparator.
FIG. 16 shows an example of an operation of the phase comparator.

### DESCRIPTION OF EMBODIMENTS

Hereinafter, preferred embodiments of the present disclosure will be described in detail. The following embodiments do not unduly limit the description in "What is Claimed is", and not all of the configurations described in the embodiments are necessarily essential component elements.

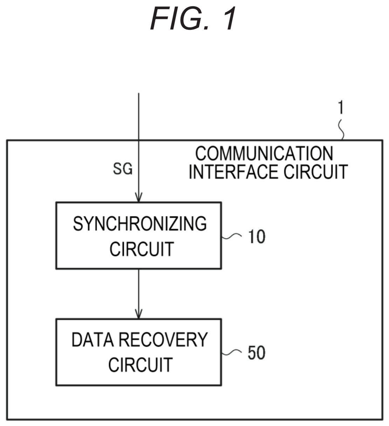

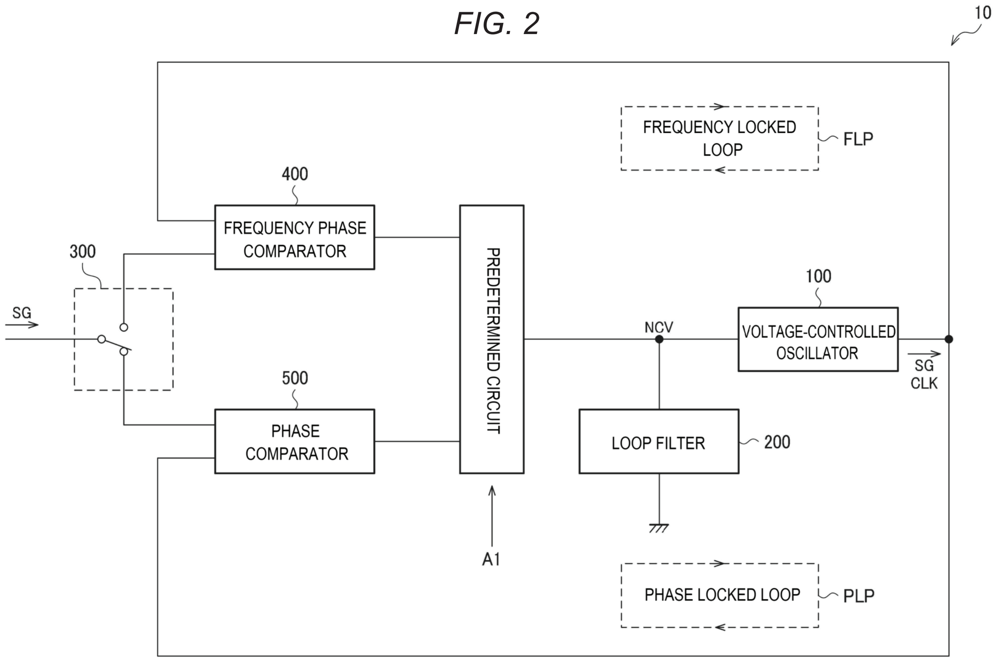

FIG. 1 is a block diagram showing a configuration example of a communication interface circuit 1 including a synchronizing circuit 10 of the present embodiment. The communication interface circuit 1 is provided in a receiving device (not illustrated) and receives an input signal SG input from an external device. The input signal SG is input to the synchronizing circuit 10 via a buffer circuit (not illustrated). The details of the synchronizing circuit 10 will be described later with reference to FIG. 2 and subsequent drawings.

The communication interface circuit 1 of the present embodiment may further include a data recovery circuit 50. The data recovery circuit 50 recovers data contained in the input signal SG. Although the synchronizing circuit 10 and the data recovery circuit 50 are separately illustrated in FIG. 1 for convenience, the data recovery circuit 50 may be provided in the synchronizing circuit 10. More specifically, a phase comparator 500 provided in the synchronizing circuit 10 may further operate as the data recovery circuit 50, and the details thereof will be described later.

A configuration example of the synchronizing circuit 10 of the present embodiment will be described with reference to FIG. 2. The synchronizing circuit 10 includes a voltage-controlled oscillator 100, a loop filter 200, a switch circuit 300, a frequency phase comparator 400, and a phase comparator 500.

Although the detailed configuration example will be described later, the voltage-controlled oscillator 100 generates a predetermined clock signal SGCLK which is a clock signal having a frequency corresponding to the control voltage of a control voltage node NCV. The predetermined clock signal SGCLK to be output is output to the frequency phase comparator 400 of a frequency locked loop FLP described later and the phase comparator 500 of a phase locked loop PLP described later.

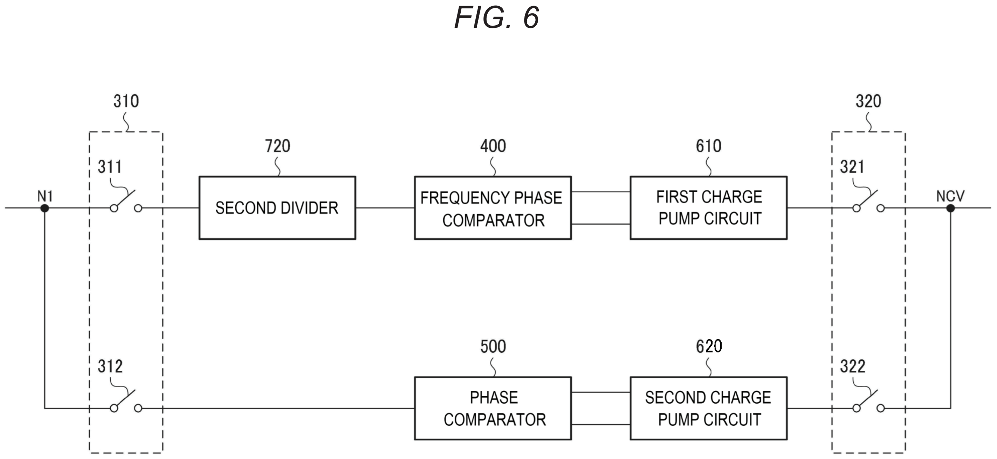

The switch circuit 300 switches between the frequency locked loop FLP and the phase locked loop PLP. Note that the switch circuit 300 in FIG. 2 is conceptually illustrated, and switching of a switch provided in the switch circuit 300 may be electrically performed using, for example, a transistor, although the details will be described later. In addition, the switch appearing in the present embodiment is exemplified by a CMOS analog switch to be described later, but implementation of on/off of the switch by a single transistor is not excluded. The same applies to the switches illustrated in FIGS. 6, 7, 8, 9, 10, and 11 described later. FIG. 2 does not limit that the switch circuit 300 is a single switch, and the switch circuit 300 may include a plurality of circuits.

The frequency phase comparator 400 compares the frequencies and phases between the predetermined clock signal SGCLK and the input signal SG. That is, the frequency phase comparator 400 is provided in the frequency locked loop FLP. A well-known configuration can be widely adopted as the configuration of the frequency phase comparator 400, and thus the detailed illustration thereof is omitted. The frequency phase comparator 400 may further include an inverter in the output stage to sharpen the waveform of the output signal. FIG. 2 shows an example in which a divider is not provided in the frequency locked loop FLP, but a divider may be provided in the frequency locked loop FLP. The range of the frequency of the input signal SG is not particularly limited, but when the frequency of the input signal SG and the frequency of the predetermined clock signal SGCLK are very high, the divider may be provided. The details of the divider will be described later.

More precisely, the input signal SG corresponds to a serial data signal at the time of data communication, but a clock signal is input as the input signal SG in a period in which locking by the frequency locked loop FLP and the phase locked loop PLP is performed. This clock signal refers to a clock signal obtained by alternately transmitting 0 and 1 as a serial data signal, at a rate half the transfer rate assumed as the input signal SG. After the phase is locked by the phase locked loop PLP, a signal actually input from an external device or the like is subjected to 8b10b conversion or the like, and data in which 0 and 1 change at regular intervals is input to the synchronizing circuit 10 as the input signal SG. The detailed description of the known method will be omitted.

Although not illustrated in FIG. 2, the frequency phase comparator 400 outputs an UP signal for further advancing the phase of the predetermined clock signal SGCLK or a DOWN signal for further delaying the phase of the predetermined clock signal SGCLK. Accordingly, for example, the UP signal is transmitted to a predetermined circuit indicated by A1, and the predetermined circuit sets the control voltage node NCV at a desired voltage so that a desired current can be fed to the loop filter 200 described later. The details of the predetermined circuit will be described later. For example, the DOWN signal is transmitted to the predetermined circuit, and the predetermined circuit sets the control voltage node NCV at a desired voltage so that a desired current can be drawn into the loop filter 200. Accordingly, the voltage-controlled oscillator 100 outputs the predetermined clock signal SGCLK based on the UP signal or the DOWN signal. The operation as the frequency locked loop FLP is implemented by the voltage-controlled oscillator 100, the loop filter 200, and the frequency phase comparator 400 configured as described above.

The phase comparator 500 compares the phases of the input signal SG and the predetermined clock signal SGCLK after the frequency is locked. That is, the phase comparator 500 is provided in the phase locked loop PLP. Although the detailed configuration example of the phase comparator 500 will be described later, the phase comparator 500 may be of a half-rate type or a Bang-Bang type, and the technique of the present embodiment can be implemented by appropriately changing a part of the configuration of the synchronizing circuit 10 depending on a phase comparison method to be adopted. Although not illustrated in FIG. 2, the phase comparator 500 outputs an UP signal for further advancing the phase of the predetermined clock signal SGCLK or a DOWN signal for further delaying the phase of the predetermined clock signal SGCLK. Similar to the frequency phase comparator 400, the voltage-controlled oscillator 100 outputs the predetermined clock signal SGCLK based on the UP signal or the DOWN signal output from the phase comparator 500.

The loop filter 200 is coupled to the control voltage node NCV. The loop filter 200 is, for example, a low-pass filter, and more specifically, a passive filter. The passive filter includes, for example, a lead filter as a filter in which a resistor and a capacitor are coupled in series between the control voltage node NCV and a ground node. In the present embodiment, the loop filter 200 as a passive filter is exemplified, but the loop filter 200 may be, for example, an active filter.

Furthermore, in the present embodiment, although the details will be described later, the loop filter 200 can perform the first loop filter processing based on first filter characteristics and the second loop filter processing based on second filter characteristics. The first filter characteristics are different from the second filter characteristics. Specifically, for example, the cutoff frequency related to the first filter characteristics is different from the cutoff frequency related to the second filter characteristics. More specifically, the time constant of the lead filter related to the first filter characteristics is different from the time constant of the lead filter related to the second filter characteristics. Although the details will be described later, the loop filter 200 can switch between the first filter characteristics and the second filter characteristics with desired timing. Therefore, in the present embodiment, the desired timing is set to timing of switching from the frequency locked loop FLP to the phase locked loop PLP. Accordingly, for example, the loop filter 200 can perform the first loop filter processing in the frequency locked loop FLP, and the loop filter 200 can perform the second loop filter processing in the phase locked loop PLP.

As described above, the synchronizing circuit 10 of the present embodiment includes the voltage-controlled oscillator 100 that generates the predetermined clock signal SGCLK as the clock signal having a frequency corresponding to the control voltage of the control voltage node NCV, the loop filter 200 coupled to the control voltage node NCV, and the switch circuit 300 that switches between the frequency locked loop FLP and the phase locked loop PLP. The frequency locked loop FLP includes the frequency phase comparator 400, the loop filter 200, and the voltage-controlled oscillator 100, and performs frequency synchronization between the predetermined clock signal SGCLK and the input signal SG. The phase locked loop PLP includes the phase comparator 500, the loop filter 200, and the voltage-controlled oscillator 100, and performs phase synchronization between the predetermined clock signal SGCLK and the input signal SG. When the frequency locked loop FLP is selected by the switch circuit 300, the loop filter 200 performs the first loop filter processing as the loop filter processing of the first filter characteristics. When the phase locked loop PLP is selected by the switch circuit 300, the loop filter 200 performs the second loop filter processing as the loop filter processing of the second filter characteristics different from the first filter characteristics.

As described above, since the synchronizing circuit 10 of the present embodiment includes the voltage-controlled oscillator 100 and the loop filter 200, the frequency locked loop FLP can be constructed by further including the frequency phase comparator 400, and the frequency synchronization between the input signal SG and the predetermined clock signal SGCLK can be performed. Furthermore, by further including the phase comparator 500, it is possible to construct the phase locked loop PLP and perform phase synchronization between the input signal SG and the predetermined clock signal SGCLK. Moreover, by further including the switch circuit 300, the synchronizing circuit 10 can switch between the frequency locked loop FLP and the phase locked loop PLP. In addition, since the loop filter 200 performs the first loop filter processing when the frequency locked loop FLP is selected and performs the second loop filter processing when the phase locked loop PLP is selected, it is possible to perform appropriate filter processing according to the selected loop. For example, as will be described later, the input signal SG and the predetermined clock signal SGCLK are divided in the frequency locked loop FLP, whereas the input signal SG and the predetermined clock signal SGCLK are not divided in the phase locked loop PLP, so that the comparison frequencies are different. Therefore, the filter characteristics required for the loop filter 200 may be different in each loop. In this regard, by applying the technique of the present embodiment, different loop filter processing is performed in the frequency locked loop FLP and the phase locked loop PLP, and thus the synchronizing circuit 10 can be more appropriately operated by the single loop filter 200.

The technique of the present embodiment may be implemented by the communication interface circuit 1. That is, the communication interface circuit 1 of the present embodiment includes the synchronizing circuit 10. For example, a half-rate clock signal is input as the input signal SG, which is originally a serial data signal. Then, the synchronizing circuit 10 performs frequency lock by the frequency locked loop FLP, and then performs phase lock by the phase locked loop PLP. Then, the serial data signal in which the clock signal is embedded by 8b10b or the like is input as the input signal SG, and the synchronizing circuit 10 recovers the clock signal from the input signal SG by the phase locked loop PLP. According to the communication interface circuit 1 of the present embodiment, the same effect as described above can be obtained in the switching between the frequency locked loop FLP and the phase locked loop PLP.

The communication interface circuit 1 further includes the data recovery circuit 50 that recovers the data of the input signal SG based on the predetermined clock signal SGCLK generated by the phase locked loop PLP. According to the configuration, it is possible to operate the device provided in the communication interface circuit 1 based on the data of the input signal SG whose phase is locked by the synchronizing circuit 10 having the above-described effects.

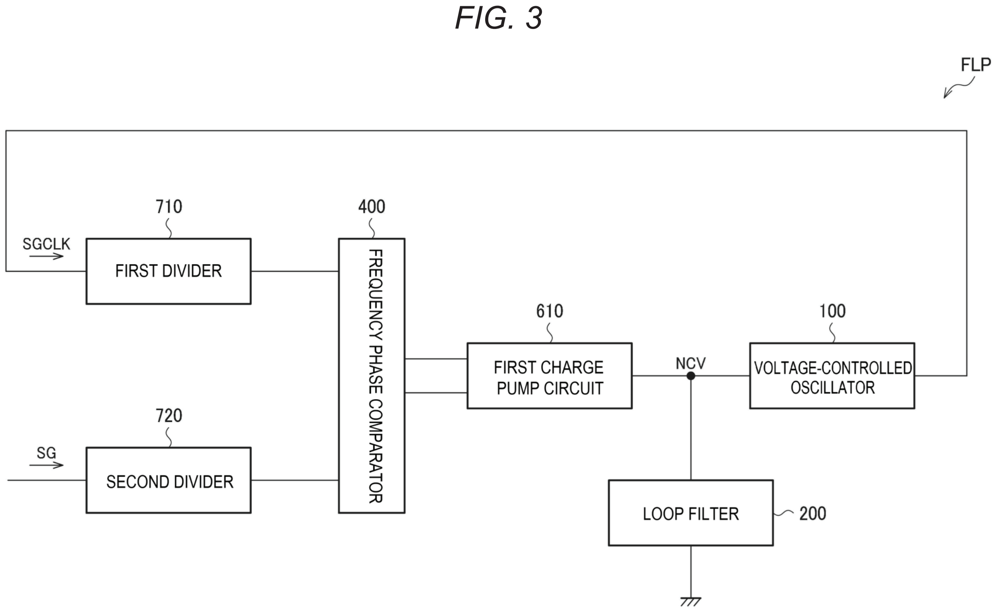

The technique of the present embodiment is not limited to the above described technique. Various modifications such as addition of another component can be implemented. For example, the synchronizing circuit 10 may include a first charge pump circuit 610, and may further include a first divider 710 and a second divider 720. More specifically, for example, as shown in FIG. 3, the first charge pump circuit 610, the first divider 710, and the second divider 720 may be provided in the frequency locked loop FLP.

The first divider 710 is disposed between the voltage-controlled oscillator 100 and the frequency phase comparator 400, and divides the predetermined clock signal SGCLK. The second divider 720 is disposed between an input node N1 as the input node of the input signal SG and the frequency phase comparator 400, and divides the input signal SG. The division ratio of the first divider 710 and the division ratio of the second divider 720 are the same. Furthermore, since known configurations can be widely adopted to the first divider 710 and the second divider 720, the detailed illustration thereof is omitted. The same applies to a third divider 730 and a fourth divider 740 described later.

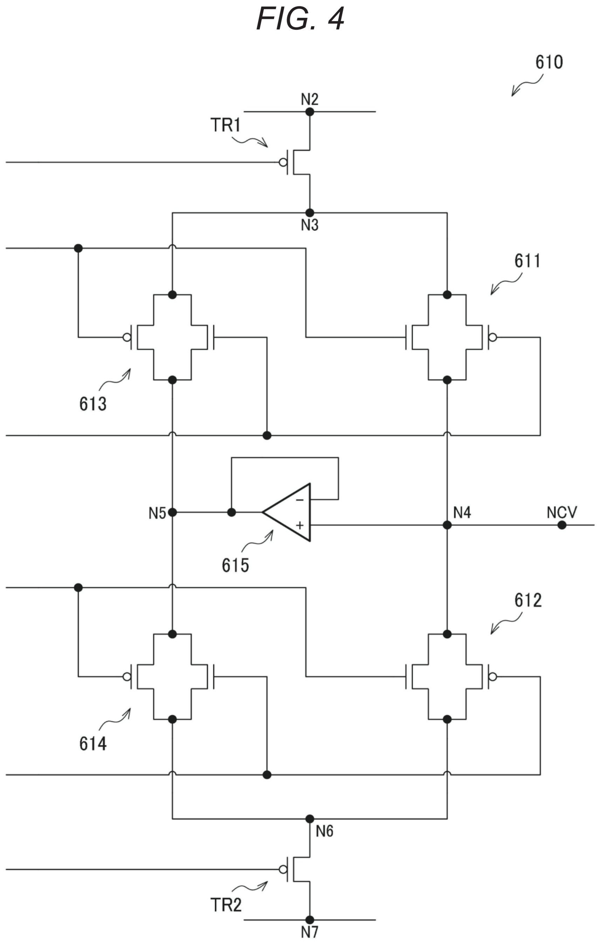

The first charge pump circuit 610 can be configured as shown in FIG. 4, for example. In FIG. 4, the first charge pump circuit 610 includes a first transistor TR1, a first predetermined switch 611, a second predetermined switch 612, a third predetermined switch 613, a fourth predetermined switch 614, a voltage follower 615, an output node N4, and a second transistor TR2. The first transistor TR1 is a P-type MOS transistor, the source of the first transistor TR1 is coupled to a node N2 which is a high-potential-side power supply node, and the drain of the first transistor TR1 is coupled to a node N3. The first transistor TR1 operates as a current source of the UP signal. The first predetermined switch 611 is disposed between the node N3 and the output node N4. The output node N4 is coupled to the control voltage node NCV. The second predetermined switch 612 is disposed between the output node N4 and a node N6. The second transistor TR2 is an N-type MOS transistor, the drain of the second transistor TR2 is coupled to the node N6, and the source of the second transistor TR2 is coupled to a node N7 which is a low-potential-side power supply node. The second transistor TR2 operates as a current source of the DOWN signal. A bias voltage is supplied to each of the gate of the first transistor TR1 and the gate of the second transistor TR2.

The first charge pump circuit 610 increases or decreases the voltage output to the loop filter 200, that is, the voltage at the control voltage node NCV in response to the UP signal or the DOWN signal output from the frequency phase comparator 400. More specifically, in the first charge pump circuit 610, when the UP signal output from the frequency phase comparator 400 is at a high level, the first predetermined switch 611 is turned on and the second predetermined switch 612 is turned off. Accordingly, a current based on the UP signal flows into the loop filter 200 as a source current. In contrast, in the first charge pump circuit 610, when the DOWN signal output from the frequency phase comparator 400 is at the high level, the first predetermined switch 611 is turned off and the second predetermined switch 612 is turned on. Accordingly, a current based on the DOWN signal is drawn into the loop filter 200 as a sink current. In FIG. 4, the third predetermined switch 613 is disposed between the node N3 and a node N5, and the fourth predetermined switch 614 is disposed between the node N5 and the node N6. The input node of the voltage follower 615 is coupled to the output node N4, and the output node of the voltage follower 615 is coupled to the node N5. Accordingly, the voltage of the node N5 is equal to the voltage of the output node N4. When the first predetermined switch 611 is off, the third predetermined switch 613 is on, and when the second predetermined switch 612 is off, the fourth predetermined switch 614 is on. Accordingly, since the first transistor TR1 or the second transistor TR2 as the current source can constantly cause a current to flow, it is possible to prevent the occurrence of a delay or noise due to on/off of the current source.

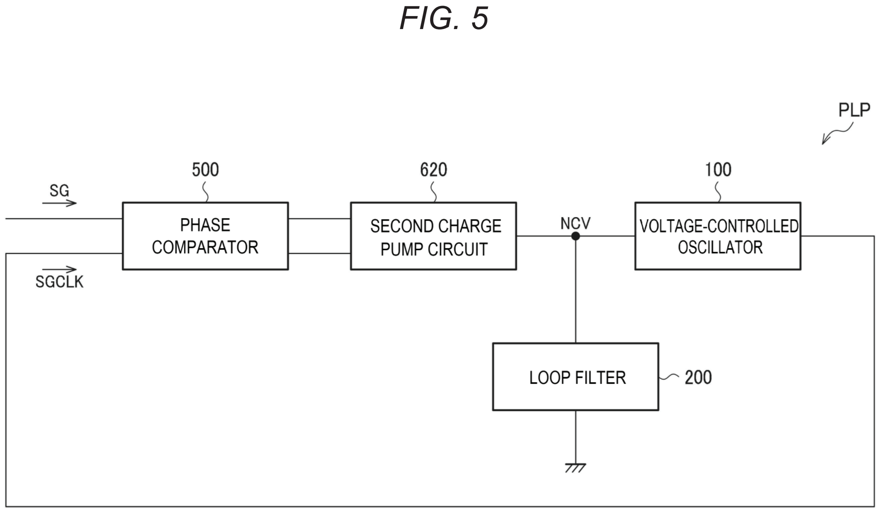

The synchronizing circuit 10 may further include a second charge pump circuit 620. More specifically, for example, as shown in FIG. 5, the second charge pump circuit 620 may be provided in the phase locked loop PLP. The second charge pump circuit 620 increases or decreases the voltage output to the loop filter 200 in response to the UP signal or the DOWN signal output from the phase comparator 500. The basic configuration and operation of the second charge pump circuit 620 are the same as those of the first charge pump circuit 610, but the relationship between the magnitude of the current based on the UP signal and the magnitude of the current based on the DOWN signal is different from that of the first charge pump circuit 610. In other words, the circuit configuration of the first charge pump circuit 610 and the circuit configuration of the second charge pump circuit 620 are the same, but the specifications of the transistors provided in the first charge pump circuit 610 and the specifications of the transistors provided in the second charge pump circuit 620 are different.

As described above, the synchronizing circuit 10 of the present embodiment further includes the first divider 710 that divides the predetermined clock signal SGCLK and the second divider 720 that divides the input signal SG. The synchronizing circuit 10 further includes the frequency phase comparator 400 that compares the output clock signal of the first divider 710 with the output clock signal of the second divider 720, the first charge pump circuit 610 that outputs the current according to the comparison result of the frequency phase comparator 400, and the second charge pump circuit 620 that outputs the current according to the comparison result of the phase comparator 500. The frequency locked loop FLP further includes the first divider 710, the second divider 720, and the first charge pump circuit 610. The phase locked loop PLP further includes the second charge pump circuit 620. According to the configuration, it is possible to construct the frequency locked loop FLP compatible with the higher rates of the input signal SG and the predetermined clock signal SGCLK, and it is possible to construct the synchronizing circuit 10 so that the frequency locked loop FLP and the phase locked loop PLP include the different charge pump circuits.

In comparison between FIGS. 3 and 5, the frequency locked loop FLP includes the first divider 710 and the second divider 720, whereas the phase locked loop PLP does not include a divider. Therefore, the frequency when the input signal SG and the predetermined clock signal SGCLK are compared in the phase locked loop PLP is higher than the frequency when the input signal SG and the predetermined clock signal SGCLK are compared in the frequency locked loop FLP.

In order to ensure a phase margin for stably operating the frequency locked loop FLP and the phase locked loop PLP, it is desirable to make the cutoff frequency as low as possible, but when the cutoff frequency is made too low, the followability to the predetermined clock signal SGCLK deteriorates. Since the frequency of the predetermined clock signal SGCLK when the phase locked loop PLP is selected is higher than the frequency of the predetermined clock signal SGCLK when the frequency locked loop FLP is selected, it is desirable to further increase the followability to the predetermined clock signal SGCLK. Therefore, it is convenient to make the cutoff frequency of the second filter characteristics used in the phase locked loop PLP higher than the cutoff frequency of the first filter characteristics used in the frequency locked loop FLP. That is, as will be described later, in the present embodiment, the time constant of the loop filter 200 related to the first filter characteristics is higher than the time constant of the loop filter 200 related to the second filter characteristics. As described above, in the synchronizing circuit 10 of the present embodiment, the comparison frequency of the phase locked loop PLP is higher than the comparison frequency of the frequency locked loop FLP, and the cutoff frequency of the second filter characteristics is higher than the cutoff frequency of the first filter characteristics. According to the configuration, it is possible to perform the appropriate loop filter processing in each of the frequency locked loop FLP and the phase locked loop PLP.

A detailed configuration example of the switch circuit 300 will be described. As shown in FIG. 6, the switch circuit 300 includes, for example, a first switch circuit 310 and a second switch circuit 320. As shown in FIG. 6, the first switch circuit 310 includes a first first-switch 311 and a first second-switch 312, and the second switch circuit 320 includes a second first-switch 321 and a second second-switch 322. That is, when the frequency locked loop FLP of the present embodiment is configured as shown in FIG. 3, the phase locked loop PLP is configured as shown in FIG. 5, and the switch circuit 300 is configured as shown in FIG. 6, the predetermined circuit indicated by A1 in FIG. 2 is more specifically a circuit including the first charge pump circuit 610, the second charge pump circuit 620, and the second switch circuit 320.

As shown in FIG. 6, the first first-switch 311 is coupled between the input node N1 and the second divider 720, and the first second-switch 312 is coupled between the input node N1 and the phase comparator 500. The second first-switch 321 is coupled between the first charge pump circuit 610 and the control voltage node NCV, and the second second-switch 322 is coupled between the second charge pump circuit 620 and the control voltage node NCV.

For example, by turning on the first first-switch 311 and the second first-switch 321 and turning off the first second-switch 312 and the second second-switch 322, the input node, the second divider 720, the frequency phase comparator 400, the first charge pump circuit 610, and the control voltage node NCV are coupled. Thus, the frequency-locked loop FLP is formed. In contrast, for example, by turning off the first first-switch 311 and the second first-switch 321 and turning on the first second-switch 312 and the second second-switch 322, the input node, the phase comparator 500, the second charge pump circuit 620, and the control voltage node NCV are coupled. Thus, the phase locked loop PLP is formed. Therefore, switching between the frequency locked loop FLP and the phase locked loop PLP can be controlled by controlling on/off of each of the first first-switch 311, the first second-switch 312, the second first-switch 321, and the second second-switch 322.

As described above, in the synchronizing circuit 10 of the present embodiment, the switch circuit 300 further includes the first switch circuit 310 including the first first-switch 311 coupled between the input node N1 to which the input signal SG is input and the second divider 720, and the first second-switch 312 coupled between the input node N1 and the phase comparator 500. The switch circuit 300 further includes the second switch circuit 320 including the second first-switch 321 coupled between the first charge pump circuit 610 and the control voltage node NCV and a second second-switch 322 coupled between the second charge pump circuit 620 and the control voltage node NCV. When the first first-switch 311 and the second first-switch 321 are turned on, the frequency locked loop FLP is selected, and when the first second-switch 312 and the second second-switch 322 are turned on, the phase locked loop PLP is selected. According to the configuration, it is possible to construct the synchronizing circuit 10 that switches between the frequency locked loop FLP and the phase locked loop PLP by on-off control of the first switch circuit 310 and the second switch circuit 320.

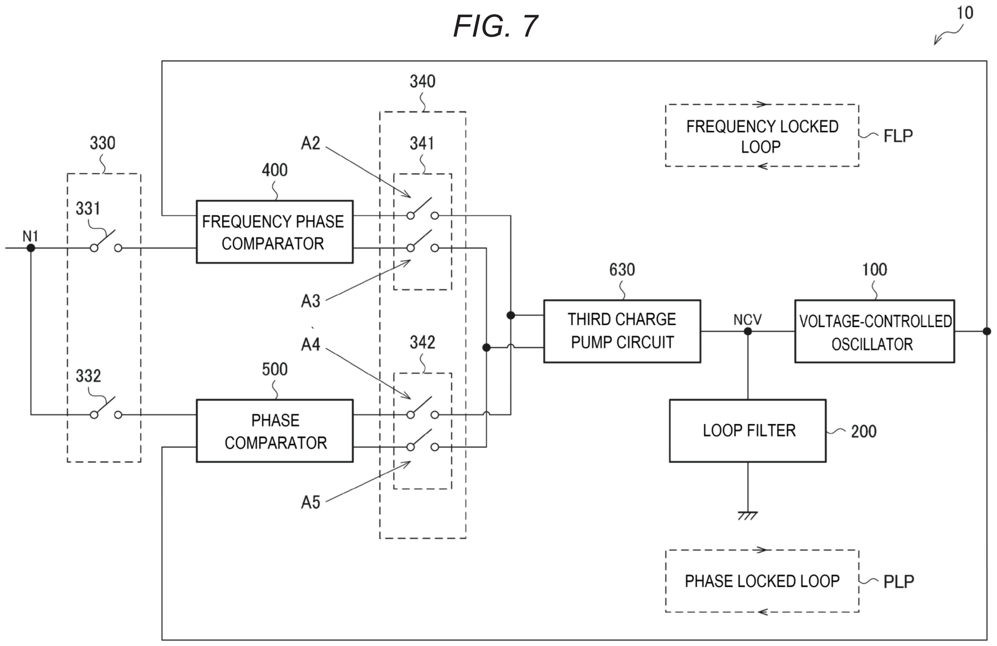

The case where the first charge pump circuit 610 and the second charge pump circuit 620 are different from each other has been described above, however, for example, when a predetermined condition is satisfied, the synchronizing circuit 10 may be formed as in the configuration example shown in FIG. 7. The synchronizing circuit 10 in FIG. 7 is the same as the synchronizing circuit 10 in FIG. 2 in that the voltage-controlled oscillator 100, the loop filter 200, the switch circuit 300, the frequency phase comparator 400, and the phase comparator 500 are provided. Furthermore, the synchronizing circuit 10 in FIG. 7 is the same as the synchronizing circuit 10 in FIG. 2 in that the frequency locked loop FLP and the phase locked loop PLP are switched by on/off control of the switch circuit 300. In contrast, the synchronizing circuit 10 in FIG. 7 is different from the synchronizing circuit 10 in FIG. 2 in that a third charge pump circuit 630 is further provided. Furthermore, the synchronizing circuit 10 in FIG. 7 is the same as the synchronizing circuit 10 in FIG. 2 in that the voltage-controlled oscillator 100, the loop filter 200, and the frequency phase comparator 400 form the frequency locked loop FLP, but is different in that the frequency locked loop FLP further includes the third charge pump circuit 630. Moreover, the synchronizing circuit 10 in FIG. 7 is the same as the synchronizing circuit 10 in FIG. 2 in that the voltage-controlled oscillator 100, the loop filter 200, and the phase comparator 500 form the phase locked loop PLP, but is different in that the phase locked loop PLP further includes the third charge pump circuit 630. In other words, the synchronizing circuit 10 in FIG. 7 is the same as the synchronizing circuit 10 in FIG. 2 in that the voltage-controlled oscillator 100 and the loop filter 200 are shared by the frequency locked loop FLP and the phase locked loop PLP, but is different from the synchronizing circuit 10 in FIG. 2 in that the third charge pump circuit 630 is further shared by the frequency locked loop FLP and the phase locked loop PLP.

The third charge pump circuit 630 can be shared by the frequency locked loop FLP and the phase locked loop PLP as shown in FIG. 7, and this means that the operation of the third charge pump circuit 630 is the same between the frequency locked loop FLP and the phase locked loop PLP. That is, the predetermined condition is that the relationship of magnitude of currents between the UP signal and the DOWN signal output from the frequency phase comparator 400 is the same as the relationship of magnitude of currents between the UP signal and the DOWN signal output from the phase comparator 500. Although the illustration of the operation and the like is omitted in the present embodiment, for example, when the phase comparator 500 is of a Bang-Bang type, the predetermined condition can be satisfied.

The circuit configuration and operation of the third charge pump circuit 630 are the same as those of the first charge pump circuit 610 and the second charge pump circuit 620 described above. That is, in the frequency locked loop FLP, the third charge pump circuit 630 increases or decreases the voltage at the control voltage node NCV in response to the UP signal or the DOWN signal output from the frequency phase comparator 400. In the phase locked loop PLP, the third charge pump circuit 630 increases or decreases the voltage at the control voltage node NCV in response to the UP signal or the DOWN signal output from the phase comparator 500.

As described above, the synchronizing circuit 10 of the present embodiment includes the third charge pump circuit 630 that outputs a current according to the comparison result of the frequency phase comparator 400 to the control voltage node NCV when the frequency locked loop FLP is selected by the switch circuit 300, and outputs a current according to the comparison result of the phase comparator 500 to the control voltage node NCV when the phase locked loop PLP is selected by the switch circuit 300. The frequency locked loop FLP further includes the third charge pump circuit 630. The phase locked loop PLP further includes the third charge pump circuit 630. According to the configuration, since the third charge pump circuit 630 is shared by the frequency locked loop FLP and the phase locked loop PLP, it is possible to construct the simpler synchronizing circuit 10.

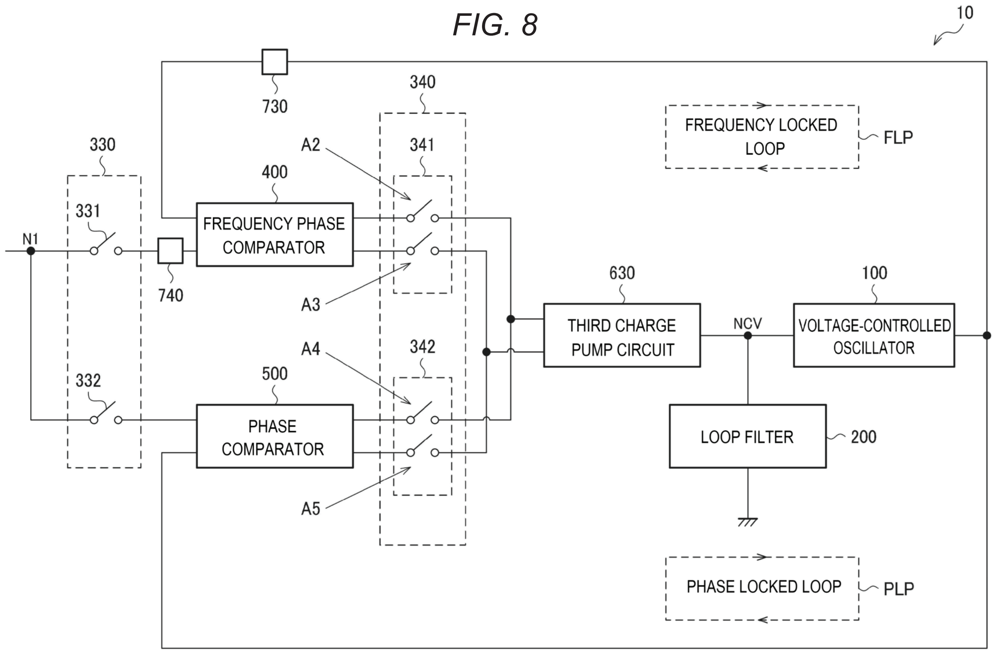

The synchronizing circuit 10 in FIG. 7 may further include the third divider 730 and the fourth divider 740. More specifically, for example, as illustrated in FIG. 8, the third divider 730 and the fourth divider 740 are provided in the frequency locked loop FLP. Accordingly, when the frequency locked loop FLP is selected, the third divider 730 divides the predetermined clock signal SGCLK output from the voltage-controlled oscillator 100, and the fourth divider 740 divides the input signal SG. The division ratio of the third divider 730 and the division ratio of the fourth divider 740 are the same. Accordingly, the frequency phase comparator 400 compares the output clock signal from the third divider 730 with the output clock signal from the fourth divider 740, and outputs an UP signal or a DOWN signal as a comparison result to the third charge pump circuit 630. As described above, the synchronizing circuit 10 of the present embodiment includes the third divider 730 and the fourth divider 740 that divide the predetermined clock signal SGCLK. The frequency phase comparator 400 compares the output clock signal of the third divider 730 with the output clock signal of the fourth divider 740. The frequency locked loop FLP further includes the third divider 730 and the fourth divider 740. According to the configuration, it is possible to construct the synchronizing circuit 10 that is compatible with a case where the frequency of the input signal SG and the frequency of the predetermined clock signal SGCLK are high and has a simple configuration.

More specifically, the switch circuit 300 when using the synchronizing circuit 10 in FIG. 7 includes a third switch circuit 330 and a fourth switch circuit 340. The third switch circuit 330 includes a third first-switch 331 and a third second-switch 332, and the fourth switch circuit 340 includes a fourth first-switch 341 and a fourth second-switch 342. The same applies to the synchronizing circuit 10 in FIG. 8. Note that a switch indicated by A2 in FIG. 7 is an UP signal switch in the fourth first-switch 341, and a switch indicated by A3 is a DOWN signal switch in the fourth first-switch 341. Similarly, a switch indicated by A4 in FIG. 7 is a switch for an UP signal in the fourth second-switch 342, and a switch indicated by A5 is a switch for a DOWN signal in the fourth second-switch 342. The same applies to switches indicated by A2 to A5 in FIG. 8. That is, when the synchronizing circuit 10 is configured as shown in FIG. 7 or 8, the predetermined circuit indicated by A1 in FIG. 2 is a circuit including the fourth switch circuit 340 and the third charge pump circuit 630.

The third first-switch 331 is coupled between the input node N1 and the frequency phase comparator 400, and the third second-switch 332 is coupled between the input node N1 and the phase comparator 500. The fourth first-switch 341 is coupled between the frequency phase comparator 400 and the third charge pump circuit 630, and the fourth second-switch 342 is coupled between the phase comparator 500 and the third charge pump circuit 630.

For example, by turning on the third first-switch 331 and the fourth first-switch 341 and turning off the third second-switch 332 and the fourth second-switch 342, the input node N1, the frequency phase comparator 400, the third charge pump circuit 630, and the control voltage node NCV are coupled. Thus, the frequency locked loop FLP is formed. In contrast, for example, by turning off the third first-switch 331 and the fourth first-switch 341 and turning on the third second-switch 332 and the fourth second-switch 342, the input node N1, the phase comparator 500, the third charge pump circuit 630, and the control voltage node NCV are coupled. Thus, the phase locked loop PLP is configured. Therefore, switching between the frequency locked loop FLP and the phase locked loop PLP in the synchronizing circuit 10 of FIG. 7 or 8 can be controlled by controlling on/off of each of the third first-switch 331, the third second-switch 332, the fourth first-switch 341, and the fourth second-switch 342.

As described above, in the synchronizing circuit 10 of the present embodiment, the switch circuit 300 further includes the third switch circuit 330 including the third first-switch 331 coupled between the input node N1 to which the input signal SG is input and the frequency phase comparator 400, and the third second-switch 332 coupled between the input node N1 and the phase comparator 500. The switch circuit 300 further includes the fourth switch circuit 340 including the fourth first-switch 341 coupled between the frequency phase comparator 400 and the third charge pump circuit 630, and the fourth second-switch 342 coupled between the phase comparator 500 and the third charge pump circuit 630. When the third first-switch 331 and the fourth first-switch 341 are turned on, the frequency locked loop FLP is selected, and when the third second-switch 332 and the fourth second-switch 342 are turned on, the phase locked loop PLP is selected. According to the configuration, it is possible to control the switching between the frequency locked loop FLP and the phase locked loop PLP by turning on and off the third switch circuit 330 and the fourth switch circuit 340, and construct the synchronizing circuit 10 having the simple configuration.

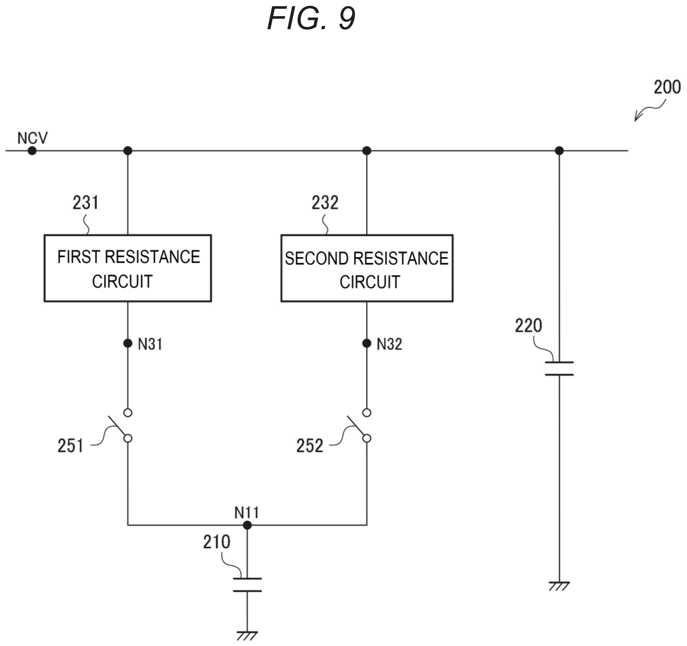

Next, an example of a specific technique of making the first loop filter processing and the second loop filter processing different will be described. For example, the loop filter 200 is formed as in the configuration example shown in FIG. 9, and thus the first loop filter processing and the second loop filter processing can be made different.

In FIG. 9, the loop filter 200 includes a first capacitor 210, a first resistance circuit 231, a second resistance circuit 232, a fifth first-switch 251, and a fifth second-switch 252. One end of the first capacitor 210 is coupled to a ground node, and the other end of the first capacitor 210 is coupled to a node N11.

The first resistance circuit 231 is disposed between the control voltage node NCV and the first capacitor 210. More specifically, one end of the first resistance circuit 231 is coupled to the control voltage node NCV, and the other end of the first resistance circuit 231 is coupled to a node N31. The second resistance circuit 232 is disposed between the control voltage node NCV and the first capacitor 210. More specifically, one end of the second resistance circuit 232 is coupled to the control voltage node NCV, and the other end of the second resistance circuit 232 is coupled to a node N32. The fifth first-switch 251 is disposed between the node N31 and the node N11. The fifth second-switch 252 is disposed between the node N32 and the node N11.

In the present embodiment, when the frequency locked loop FLP is selected, the first filter characteristics are determined based on the resistance value of the first resistance circuit 231 and the capacitance value of the first capacitor 210, and when the phase locked loop PLP is selected, the second filter characteristics are determined based on the resistance value of the second resistance circuit 232 and the capacitance value of the first capacitor 210. More specifically, for example, the fifth first-switch 251 is turned on and the fifth second-switch 252 is turned off at the timing when the frequency locked loop FLP is selected, and thus the loop filter 200 in which the control voltage node NCV, the first resistance circuit 231, and the first capacitor 210 are coupled in series is configured. Furthermore, for example, when the fifth first-switch 251 is turned off and the fifth second-switch 252 is turned on at the timing when the phase locked loop PLP is selected, the loop filter 200 in which the control voltage node NCV, the second resistance circuit 232, and the first capacitor 210 are coupled in series is configured.

Although FIG. 9 illustrates that the fifth first-switch 251 is disposed between the first resistance circuit 231 and the node N11, the fifth first-switch 251 may be disposed between the control voltage node NCV and the first resistance circuit 231. Similarly, although FIG. 9 illustrates that the fifth second-switch 252 is disposed between the second resistance circuit 232 and the node N11, the fifth second-switch 252 may be disposed between the control voltage node NCV and the second resistance circuit 232.

As described above, in the synchronizing circuit 10 of the present embodiment, the loop filter 200 includes the first capacitor 210 having one end coupled to the ground node, the first resistance circuit 231 and the fifth first-switch 251 coupled in series between the control voltage node NCV and the other end of the first capacitor 210, and the second resistance circuit 232 and the fifth second-switch 252 coupled in series between the control voltage node NCV and the other end of the first capacitor 210. When the frequency locked loop FLP is selected by the switch circuit 300, the fifth first-switch 251 is turned on, and when the phase locked loop PLP is selected by the switch circuit 300, the fifth second-switch 252 is turned on. According to the configuration, it is possible to construct the synchronizing circuit 10 including the loop filter 200 including different resistance circuits for the frequency locked loop FLP and the phase locked loop PLP.

The loop filter 200 described above is an example of operating as a primary passive filter including the first resistance circuit 231 and the first capacitor 210 or a primary passive filter including the second resistance circuit 232 and the first capacitor 210, but the loop filter 200 may further include a second capacitor 220. The second capacitor 220 has one end coupled to the ground node and the other end coupled to the control voltage node NCV. As described above, in the synchronizing circuit 10 of the present embodiment, the loop filter 200 further includes the second capacitor 220 having one end coupled to the ground node and the other end coupled to the control voltage node NCV. According to the configuration, it is possible to construct the loop filter 200 as a secondary passive filter.

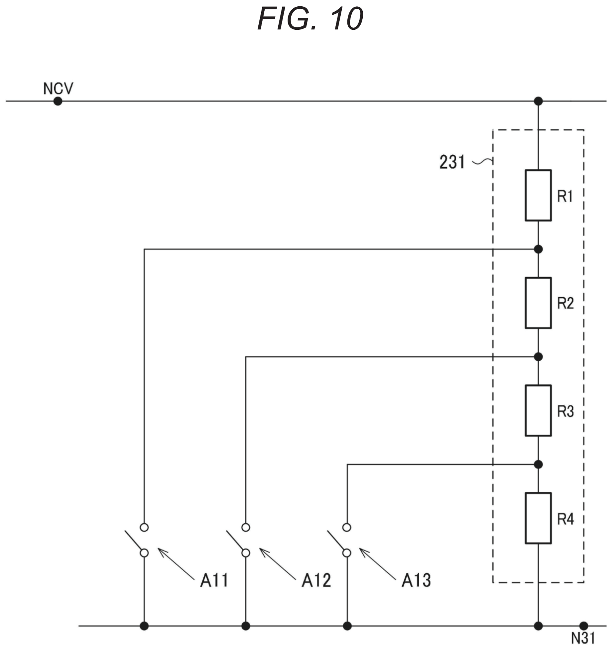

For example, as shown in FIG. 10, the resistance value of the first resistance circuit 231 may be variably set by a resistance selection circuit. The resistance selection circuit includes, for example, a switch indicated by A11, a switch indicated by A12, and a switch indicated by A13 in FIG. 10. In FIG. 10, the first resistance circuit 231 includes a unit resistor R1, a unit resistor R2, a unit resistor R3, and a unit resistor R4. One end of the unit resistor R1 is coupled to the control voltage node NCV, the other end of the unit resistor R1 is coupled to one end of the unit resistor R2, the other end of the unit resistor R2 is coupled to one end of the unit resistor R3, the other end of the unit resistor R3 is coupled to one end of the unit resistor R4, and the other end of the unit resistor R4 is coupled to the node N31. The switch indicated by A11 is coupled between a node between the unit resistor R1 and the unit resistor R2 and the node N31. The switch indicated by A12 is coupled between a node between the unit resistor R2 and the unit resistor R3 and the node N31. The switch indicated by A13 is coupled between a node between the unit resistor R3 and the unit resistor R4 and the node N31. Although not illustrated, the switches indicated by A11 to A13 are on/off-controlled by, for example, a decoder circuit or the like.

The first resistance circuit 231 and the resistance selection circuit are formed as illustrated in FIG. 10, and thus, for example, when all the switches A11 to A13 are turned off, the resistance value of the first resistance circuit 231 is the sum of the resistance values of the unit resistors R1 to R4. For example, when the switch indicated by A11 is turned on, a short circuit occurs between the unit resistor R1 and the node N31, and thus the resistance value of the first resistance circuit 231 is the resistance value of the unit resistor R1. For example, when the switch indicated by A12 is turned on, a short circuit occurs between the unit resistor R2 and the node N31, and thus the resistance value of the first resistance circuit 231 is the sum of the resistance values of the unit resistors R1 and R2. For example, when the switch indicated by A13 is turned on, a short circuit occurs between the unit resistor R3 and the node N31, and thus the resistance value of the first resistance circuit 231 is the sum of the resistance values of the unit resistors R1 to R3. As described above, by providing the first resistance circuit 231 and the resistance selection circuit illustrated in the example of FIG. 10, the resistance value of the first resistance circuit 231 can be selected in four ways.

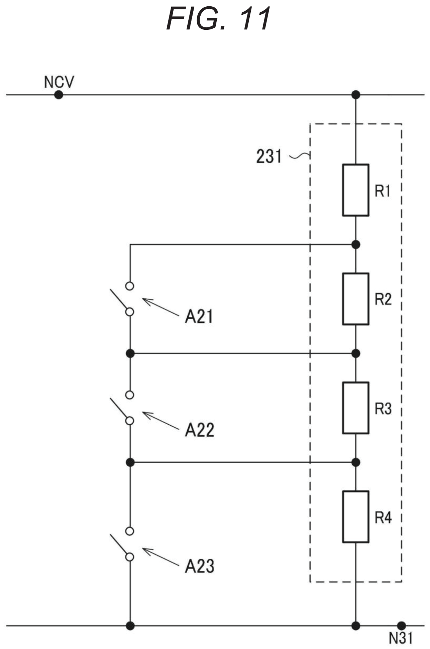

The resistance selection circuit may be formed as illustrated in FIG. 11, for example. In FIG. 11, the resistance selection circuit includes a switch indicated by A21, a switch indicated by A22, and a switch indicated by A23. It is assumed that the first resistance circuit 231 illustrated in the example of FIG. 11 is the same as that of FIG. 10. The switch indicated by A21 is coupled between a node between the unit resistor R1 and the unit resistor R2 and a node between the unit resistor R2 and the unit resistor R3. The switch indicated by A22 is coupled between a node between the unit resistor R2 and the unit resistor R3 and a node between the unit resistor R3 and the unit resistor R4. The switch indicated by A23 is coupled between a node between the unit resistor R3 and the unit resistor R4 and the node N31. Although not illustrated, the switches indicated by A21 to A23 are on/off-controlled by, for example, a decoder circuit or the like.

The first resistance circuit 231 and the resistance selection circuit are formed as illustrated in FIG. 11, and thus, for example, when all the switches A21 to A23 are turned off, the resistance value of the first resistance circuit 231 is the sum of the resistance values of the unit resistors R1 to R4. For example, when the switch indicated by A21 is turned on, a short circuit occurs between the node between the unit resistor R1 and the unit resistor R2 and the node between the unit resistor R2 and the unit resistor R3, and thus the resistance value of the first resistance circuit 231 is the sum of the resistance value of the unit resistor R1, the resistance value of the unit resistor R3, and the resistance value of the unit resistor R4. For example, when the switch indicated by A22 is turned on, a short circuit occurs between the node between the unit resistor R2 and the unit resistor R3 and the node between the unit resistor R3 and the unit resistor R4, and thus the resistance value of the first resistance circuit 231 is the sum of the resistance value of the unit resistor R1, the resistance value of the unit resistor R2, and the resistance value of the unit resistor R4. For example, when the switch indicated by A23 is turned on, a short circuit occurs between the node between the unit resistor R3 and the unit resistor R4 and the node N31, and thus the resistance value of the first resistance circuit 231 is the sum of the resistance value of the unit resistor R1, the resistance value of the unit resistor R2, and the resistance value of the unit resistor R3.

For example, when the switch indicated by A21 and the switch indicated by A22 are turned on, a short circuit occurs between the node between the unit resistor R1 and the unit resistor R2 and the node between the unit resistor R3 and the unit resistor R4, and thus the resistance value of the first resistance circuit 231 is the sum of the resistance value of the unit resistor R1 and the resistance value of the unit resistor R4. For example, when the switch indicated by A22 and the switch indicated by A23 are turned on, a short circuit occurs between the node between the unit resistor R2 and the unit resistor R3 and the node N31, and thus the resistance value of the first resistance circuit 231 is the sum of the resistance value of the unit resistor R1 and the resistance value of the unit resistor R2. For example, when the switch indicated by A21 and the switch indicated by A23 are turned on, the resistance value of the first resistance circuit 231 is the sum of the resistance value of the unit resistor R1 and the resistance value of the unit resistor R3. As described above, by providing the first resistance circuit 231 and the resistance selection circuit illustrated in the example of FIG. 11, the resistance value of the first resistance circuit 231 can be selected in eight ways.

Whether the resistance selection circuit is formed as in the example of FIG. 10 or as in the example of FIG. 11 may be appropriately determined by a user. For example, when it is desired to reduce the resistance value of the first resistance circuit 231 as much as possible, the example of FIG. 10 may be adopted. In the example of FIG. 11, the switches A21 to A23 are all turned on when the resistance value of the first resistance circuit 231 is the minimum, but the more accurate resistance value of the first resistance circuit 231 is the sum of the resistance value of the unit resistor R1 and the resistance values of the on-resistances of the three switches.

The examples of the first resistance circuit 231 and the resistance selection circuit of the present embodiment are not limited to those illustrated in FIGS. 10 and 11, and various modifications can be made. For example, the number of unit resistors provided in the first resistance circuit 231 may be other than four, the number of switches provided in the resistance selection circuit may be other than three, and may be appropriately determined by the user. In the examples of FIGS. 10 and 11, the path including the unit resistor R1 coupled to the control voltage node NCV is not short-circuited by the resistance selection circuit, but the path including the unit resistor R4 coupled to the node N31 may not be short-circuited by the resistance selection circuit.

Although FIGS. 10 and 11 show examples in which the first resistance circuit 231 is variably set, the second resistance circuit 232 may also be variably set. Accordingly, for example, the first resistance circuit 231 and the second resistance circuit 232 can be configured similarly, and the resistance value of the first resistance circuit 231 and the resistance value of the second resistance circuit 232 can be changed so that the resistance value of the first resistance circuit 231 and the resistance value of the second resistance circuit 232 are different from each other. For example, when the circuit configurations of the first resistance circuit 231 and the second resistance circuit 232 are the same, the resistance value of the first resistance circuit 231 becomes higher than the resistance value of the second resistance circuit 232 by turning off all switches of the resistance selection circuit coupled to the first resistance circuit 231 and turning on one switch of the resistance selection circuit coupled to the second resistance circuit 232. Accordingly, the time constant of the loop filter 200 including the first resistance circuit 231 is higher than the time constant of the loop filter 200 including the second resistance circuit 232. Thus, it is possible to make the cutoff frequency of the second filter characteristics higher than the cutoff frequency of the first filter characteristics. Note that one switch of the resistance selection circuit coupled to the second resistance circuit 232 may be turned on, and the on/off of the switches may be appropriately determined according to the resistance value to be specifically set for each of the first resistance circuit 231 and the second resistance circuit 232. From the above, in the synchronizing circuit 10 of the present embodiment, the first resistance circuit 231 and the second resistance circuit 232 are variable resistance circuits. According to the configuration, it is possible to make the first filter characteristics and the second filter characteristics different by more combinations. This makes it easy to set the cutoff frequency of the frequency locked loop FLP and the cutoff frequency of the phase locked loop PLP to desired frequencies.

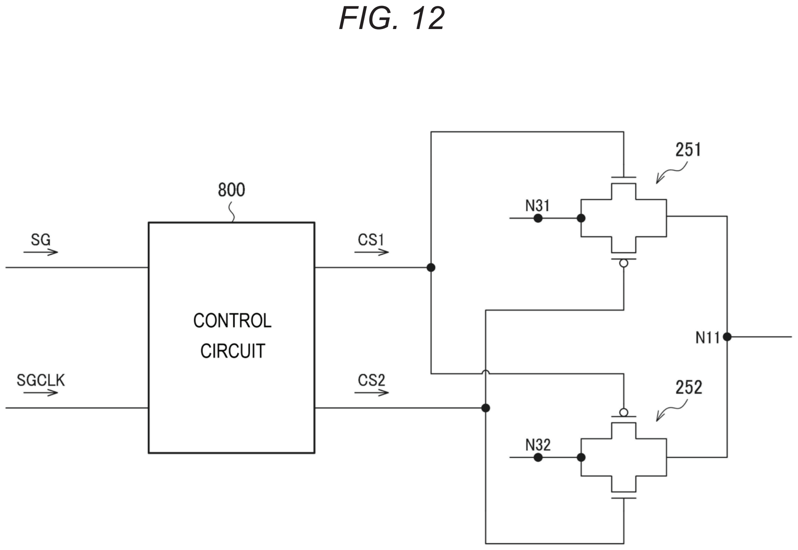

The on/off of the fifth first-switch 251 and the fifth second-switch 252 described above with reference to FIG. 9 can be implemented by, for example, a technique illustrated in FIG. 12. For example, the synchronizing circuit 10 further includes a control circuit 800. The control circuit 800 is a logic circuit that can be implemented by automatic placement and routing such as a gate array. The input signal SG and the predetermined clock signal SGCLK output from the voltage-controlled oscillator 100 are input to the control circuit 800. The control circuit 800 outputs a first control signal CS1 and a second control signal CS2.

Specifically, the fifth first-switch 251 is, for example, a CMOS analog switch including a PMOS transistor and an NMOS transistor, the first control signal CS1 is input to the gate of the NMOS transistor of the fifth first-switch 251, and the second control signal CS2 is input to the gate of the PMOS transistor of the fifth first-switch 251. The fifth second-switch 252 is a CMOS analog switch similar to the fifth first switch 251, the first control signal CS1 is input to the gate of the PMOS transistor of the fifth second-switch 252, and the second control signal CS2 is input to the gate of the NMOS transistor of the fifth second-switch 252.

The control circuit 800 determines whether the frequency is locked based on the input signal SG and the predetermined clock signal SGCLK input thereto. Specifically, for example, the control circuit 800 counts the number of pulses of the input signal SG and the number of pulses of the predetermined clock signal SGCLK, and obtains a difference number between the number of pulses of the input signal SG and the number of pulses of the predetermined clock signal SGCLK counted within a certain period. The certain period here is measured by counting a predetermined number of pulses of the input signal SG, for example, and a difference between the predetermined number of pulses of the input signal SG and the number of pulses of the predetermined clock signal SGCLK corresponds to the difference number. Then, the control circuit 800 determines that the frequency is locked when the obtained difference number is within a certain value, and determines that the frequency is not locked when the obtained difference number is larger than the certain value.

When determining that the frequency is not locked, the control circuit 800 turns on the fifth first-switch 251 and turns off the fifth second-switch 252. Specifically, for example, the control circuit 800 outputs a high-level first control signal CS1 and a low-level second control signal CS2. As a result, the node N11 and the node N31 are conducted, and the first resistance circuit 231 and the first capacitor 210 in FIG. 9 are coupled in series. Accordingly, while the frequency locked loop FLP is selected, the loop filter 200 performs the first loop filter processing based on the first resistance circuit 231 and the first capacitor 210. In contrast, when determining that the frequency is locked, the control circuit 800 turns off the fifth first-switch 251 and turns on the fifth second-switch 252. Specifically, for example, the control circuit 800 outputs a low-level first control signal CS1 and a high-level second control signal CS2. As a result, the node N11 and the node N32 are conducted, and the second resistance circuit 232 and the first capacitor 210 in FIG. 9 are coupled in series. Accordingly, while the phase locked loop PLP is selected, the loop filter 200 performs the second loop filter processing based on the second resistance circuit 232 and the first capacitor 210.

The on/off of each of the first first-switch 311, the first second-switch 312, the second first-switch 321, and the second second-switch 322 described above with reference to FIG. 6 may be controlled by the same technique. In other words, although not illustrated, all of the first first-switch 311, the first second-switch 312, the second first-switch 321, and the second second-switch 322 may be CMOS analog switches. In this case, the first control signal CS1 is input to the gate of the NMOS transistor of the first first-switch 311, and the second control signal CS2 is input to the gate of the PMOS transistor of the first first-switch 311. The first control signal CS1 is input to the gate of the PMOS transistor of the first second-switch 312, and the second control signal CS2 is input to the gate of the NMOS transistor of the first second-switch 312. The first control signal CS1 is input to the gate of the NMOS transistor of the second first-switch 321, and the second control signal CS2 is input to the gate of the PMOS transistor of the second first-switch 321. The first control signal CS1 is input to the gate of the PMOS transistor of the second second-switch 322, and the second control signal CS2 is input to the gate of the NMOS transistor of the second second-switch 322. Then, the control circuit 800 outputs the high-level first control signal CS1 and the low-level second control signal CS2, so that the first first-switch 311 and the second first-switch 321 are turned on, the first second-switch 312 and the second second-switch 322 are turned off, and the selection of the frequency locked loop FLP is implemented. Furthermore, the control circuit 800 outputs the low-level first control signal CS1 and the high-level second control signal CS2, so that the first first-switch 311 and the second first-switch 321 are turned off, the first second-switch 312 and the second second-switch 322 are turned on, and the selection of the phase-locked loop PLP is implemented.

The on/off of each of the third first-switch 331, the third second-switch 332, the fourth first-switch 341, and the fourth second-switch 342 described above with reference to FIG. 7 may be controlled by the same technique. In other words, although not illustrated, all of the third first-switch 331, the third second-switch 332, the fourth first-switch 341, and the fourth second-switch 342 may be CMOS analog switches. In this case, the first control signal CS1 is input to the gate of the NMOS transistor of the third first-switch 331, and the second control signal CS2 is input to the gate of the PMOS transistor of the third first-switch 331. The first control signal CS1 is input to the gate of the PMOS transistor of the third second-switch 332, and the second control signal CS2 is input to the gate of the NMOS transistor of the third second-switch 332. The first control signal CS1 is input to the gate of the NMOS transistor of the fourth first-switch 341, and the second control signal CS2 is input to the gate of the PMOS transistor of the fourth first-switch 341. The first control signal CS1 is input to the gate of the PMOS transistor of the fourth second-switch 342, and the second control signal CS2 is input to the gate of the NMOS transistor of the fourth second-switch 342. Then, the control circuit 800 outputs the high-level first control signal CS1 and the low-level second control signal CS2, so that the third first-switch 331 and the fourth first-switch 341 are turned on, the third second-switch 332 and the fourth second-switch 342 are turned off, and the selection of the frequency locked loop FLP is implemented. Furthermore, the control circuit 800 outputs the low-level first control signal CS1 and the high-level second control signal CS2, so that the third first-switch 331 and the fourth first-switch 341 are turned off, the third second-switch 332 and the fourth second-switch 342 are turned on, and the selection of the phase-locked loop PLP is implemented.

As described above, the synchronizing circuit 10 of the present embodiment further includes the control circuit 800 that controls the switch circuit 300 to switch from the frequency locked loop FLP to the phase locked loop PLP, turns the fifth first-switch 251 from on to off, and turns the fifth second-switch 252 from off to on when the lock of the frequency locked loop FLP is detected. According to the configuration, it is possible to electrically on/off-control the execution of the first loop filter processing by the loop filter 200 including the first resistance circuit 231 in the frequency locked loop FLP and the execution of the second loop filter processing by the loop filter 200 including the second resistance circuit 232 in the phase locked loop PLP.

The control circuit 800 configured as described above may output the high-level first control signal CS1 and the low-level second control signal CS2 when determining that the frequency is not locked, and may output the low-level first control signal CS1 and the high-level second control signal CS2 when determining that the frequency is locked. After switching to the phase locked loop PLP, the phase of the input signal SG and the phase of the predetermined clock signal SGCLK are synchronized by the phase locked loop PLP. As described above, the control circuit 800 of the present embodiment detects whether the frequency of the predetermined clock signal SGCLK output by the voltage-controlled oscillator 100 is locked to the frequency of the clock signal of the input signal SG having a predetermined rate in the frequency locked loop FLP. When the control circuit 800 detects the lock of the frequency locked loop FLP, the switch circuit 300 switches from the frequency locked loop FLP to the phase locked loop PLP. The phase locked loop PLP synchronizes the phase of the clock signal of the input signal SG, which is a data signal, with the phase of the predetermined clock signal SGCLK output by the voltage-controlled oscillator 100. According to the configuration, it is possible to construct the control circuit 800 that controls the switch circuit 300 so as to switch from the frequency locked loop FLP to the phase locked loop PLP after the frequency is locked by the frequency locked loop FLP.

The control circuit 800 may operate as the resistance selection circuit described above with reference to FIG. 10. For example, the control circuit 800 may include a nonvolatile memory, refer to a trimming value stored in the nonvolatile memory, and output a control signal for controlling on/off of the switches indicated by A11 to A13 so as to correspond to a desired trimming value. The same applies to the resistance selection circuit described above with reference to FIG. 11. Although the example in which the synchronizing circuit 10 includes the control circuit 800 is described in the present embodiment, the control circuit 800 may be provided outside the synchronizing circuit 10. Furthermore, the control circuit 800 is not limited to the logic circuit, and may be implemented by a processor such as a CPU, and the operation related to the control circuit 800 may be performed by software.

Next, the operation of the synchronizing circuit 10 of the present embodiment will be schematically described. The synchronizing circuit 10 in the following description is the synchronizing circuit 10 based on the configuration example illustrated in FIGS. 2, 3, and 5. In other words, in the following description, the phase comparator 500 provided in the phase locked loop PLP is of a half-rate type.

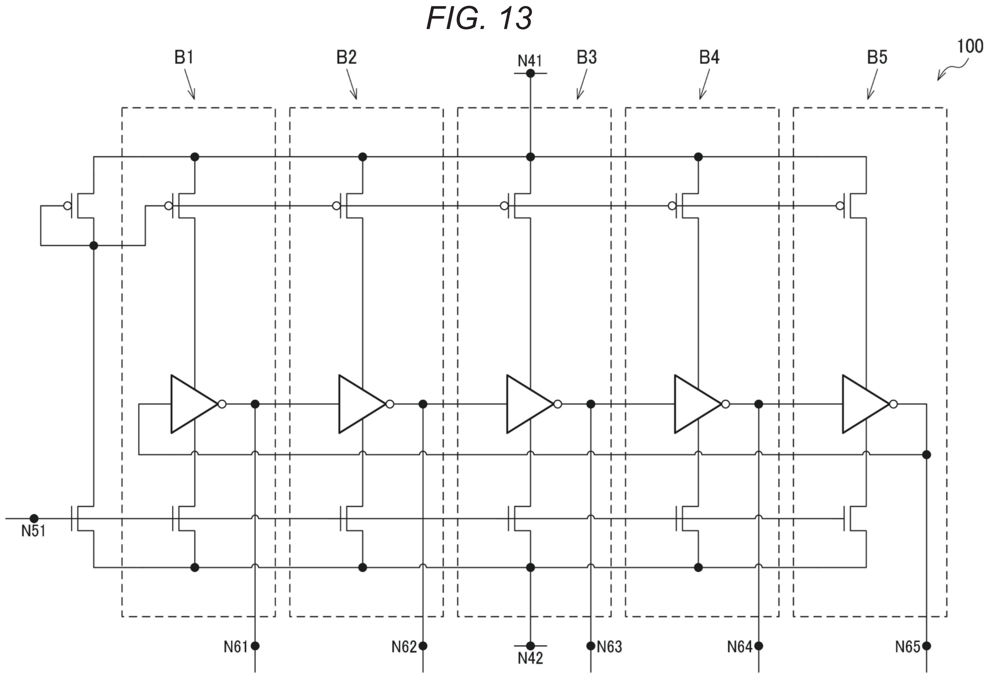

FIG. 13 shows a more detailed configuration example of the voltage-controlled oscillator 100 of the present embodiment. The voltage-controlled oscillator 100 includes a delay circuit indicated by B1, a delay circuit indicated by B2, a delay circuit indicated by B3, a delay circuit indicated by B4, and a delay circuit indicated by B5. In FIG. 13, a node N41 is a high-potential-side power supply node, a node N42 is a low-potential-side power supply node, and a node N51 is a node coupled to the control voltage node NCV. That is, the voltage-controlled oscillator 100 is a five-stage ring oscillator. Although the configuration and operation of the ring oscillator are well known and the detailed description thereof will be omitted, predetermined clock signals SGCLK having different phases from one another are output from the respective delay circuits. For example, when the predetermined clock signal SGCLK output from a node N61 is used as a reference, the predetermined clock signal SGCLK whose phase is delayed by 72 degrees is output from a node N63. Furthermore, the predetermined clock signal SGCLK whose phase is delayed by 144 degrees based on the same reference is output from a node N65, the predetermined clock signal SGCLK whose phase is delayed by 216 degrees is output from a node N62, and the predetermined clock signal SGCLK whose phase is delayed by 288 degrees is output from a node N64.

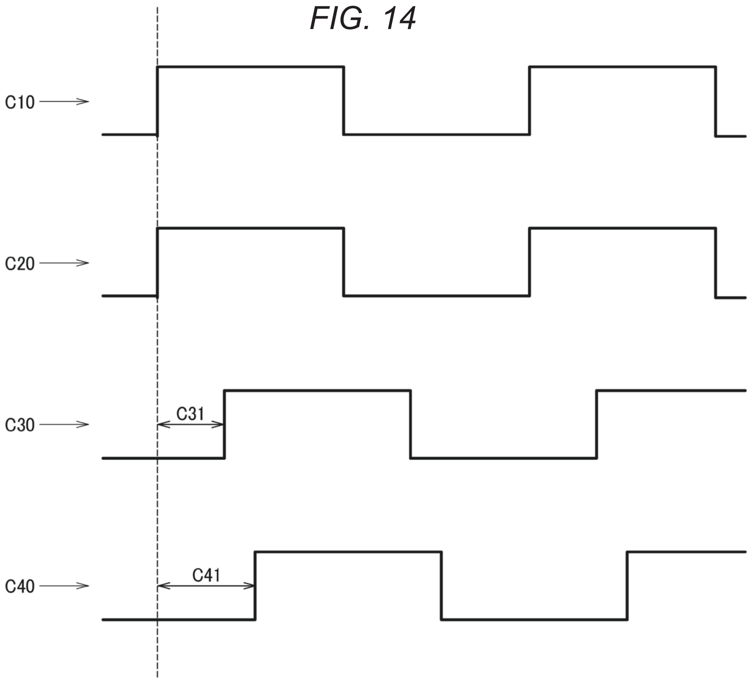

In the synchronizing circuit 10 of the present embodiment, while the frequency locked loop FLP is selected, frequency lock is performed based on, for example, the predetermined clock signal SGCLK output from the node N61. Conceptually, when a signal indicated by C10 in FIG. 14 is the input signal SG and a signal indicated by C20 is the predetermined clock signal SGCLK, the rising edge of the input signal SG coincides with the rising edge of the predetermined clock signal SGCLK, and the frequency is locked.

Then, when the phase locked loop PLP is selected, the predetermined clock signal SGCLK output from the node N63 of the voltage-controlled oscillator 100 is input to the phase comparator 500. That is, when the waveform of the input signal SG at the timing when the phase locked loop PLP is selected and the phase synchronization between the input signal SG and the predetermined clock signal SGCLK is started is the waveform indicated by C10 in FIG. 14, the waveform of the predetermined clock signal SGCLK at the same timing is a waveform indicated by C30 in FIG. 14. In the waveform indicated by C30, a phase difference indicated by C31 is a difference between the phase of the waveform output from the node N61 and the phase of the waveform output from the node N63 in FIG. 13, and corresponds to 72 degrees.

In the synchronizing circuit 10 based on the configuration described above with reference to FIGS. 2, 3, and 5, when the phase of the predetermined clock signal SGCLK is delayed by 90 degrees with respect to the phase of the input signal SG, the phase is locked. That is, when the waveform of the input signal SG in the state where the phases of the input signal SG and the predetermined clock signal SGCLK are locked by the phase locked loop PLP is the waveform indicated by C10 in FIG. 14, the waveform of the predetermined clock signal SGCLK in the same state is a waveform indicated by C40 in FIG. 14. In the waveform indicated by C40, a phase difference indicated by C41 corresponds to 90 degrees. As described above, rather than delaying the phase of the predetermined clock signal SGCLK by 90 degrees with respect to the phase of the input signal SG from the state where the predetermined clock signal SGCLK and the input signal SG are in the same phase, delaying the phase of the predetermined clock signal SGCLK by 90 degrees from the state where the phase of the predetermined clock signal SGCLK is delayed by 72 degrees with respect to the phase of the input signal SG is more convenient for locking the phase.

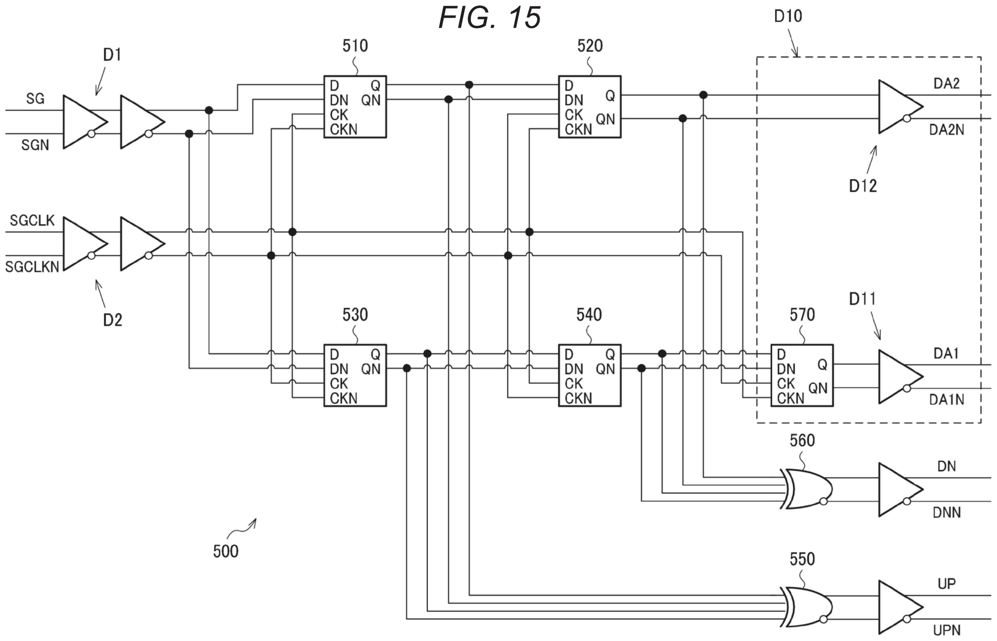

FIG. 15 shows a more detailed configuration example of the phase comparator 500. FIG. 15 shows an example of a differential circuit. More specifically, for example, the input signal SG and a signal SGN, which is a logically inverted signal of the input signal SG, are input to a buffer indicated by D1 in FIG. 15. Similarly, a signal SGCLKN is a logically inverted signal of the predetermined clock signal SGCLK. Although the details will be described later, a signal UP and a signal UPN which is a logically inverted signal thereof illustrated in FIG. 15 are UP signals output from the phase comparator 500, and a signal DN and a signal DNN which is a logically inverted signal thereof are DOWN signals output from the phase comparator 500. Furthermore, although the details will be described later, a signal DA1 output from a buffer D11 in FIG. 15 and a signal DA1N which is a logically inverted signal thereof are signals related to data contained in a first data block described later, and a signal DA2 output from a buffer D12 and a signal DA2N which is a logically inverted signal thereof are signals related to data contained in a second data block described later. Hereinafter, in order to simplify the description, only a positive signal of a differential signal may be described. The phase comparator 500 includes a master latch circuit 510, a slave latch circuit 520, a master latch circuit 530, a slave latch circuit 540, an exclusive OR circuit 550, and an exclusive OR circuit 560. The input signal SG is input to the master latch circuit 510 and the master latch circuit 530 via the buffer indicated by D1 in FIG. 15. The predetermined clock signal SGCLK is input to the master latch circuit 510, the slave latch circuit 520, the master latch circuit 530, and the slave latch circuit 540 via a buffer indicated by D2. The phase comparator 500 may further include a flip-flop circuit 570, and the predetermined clock signal SGCLK may be input to the flip-flop circuit 570. The flip-flop circuit 570 will be described later.

In the phase comparator 500 in FIG. 15, the master latch circuit 510 and the slave latch circuit 520 form a master-slave flip-flop circuit of a falling edge trigger, and the master latch circuit 530 and the slave latch circuit 540 form a master-slave flip-flop circuit of a rising edge trigger. Specifically, for example, the master latch circuit 510 captures the input of the input signal SG when the predetermined clock signal SGCLK is at a high level, and holds the captured input when the predetermined clock signal SGCLK is at a low level. The slave latch circuit 520 holds the captured input when the predetermined clock signal SGCLK is at a high level, and captures the input from the master latch circuit 510 when the predetermined clock signal SGCLK is at a low level. The master latch circuit 530 captures the input of the input signal SG when the predetermined clock signal SGCLK is at the low level, and holds the captured input when the predetermined clock signal SGCLK is at the high level. The slave latch circuit 540 captures the input from the master latch circuit 530 when the predetermined clock signal SGCLK is at the high level, and holds the captured input when the predetermined clock signal SGCLK is at the low level.

In the phase comparator 500 in FIG. 15, the exclusive OR circuit 550 outputs an exclusive OR of the output of the master latch circuit 510 and the output of the master latch circuit 530. The exclusive OR circuit 560 outputs an exclusive OR of the output of the slave latch circuit 520 and the output of the slave latch circuit 540. In the present embodiment, the output signal of the exclusive OR circuit 550 is an UP signal, and the output signal of the exclusive OR circuit 560 is a DOWN signal. In the present embodiment, the output signals of the slave latch circuit 520 and the flip-flop circuit 570 are signals obtained by deserializing the input signal SG, which is a serial data signal, as 2-bit parallel signals. In other words, the phase comparator 500 in FIG. 15 includes the data recovery circuit 50 described above with reference to FIG. 1.

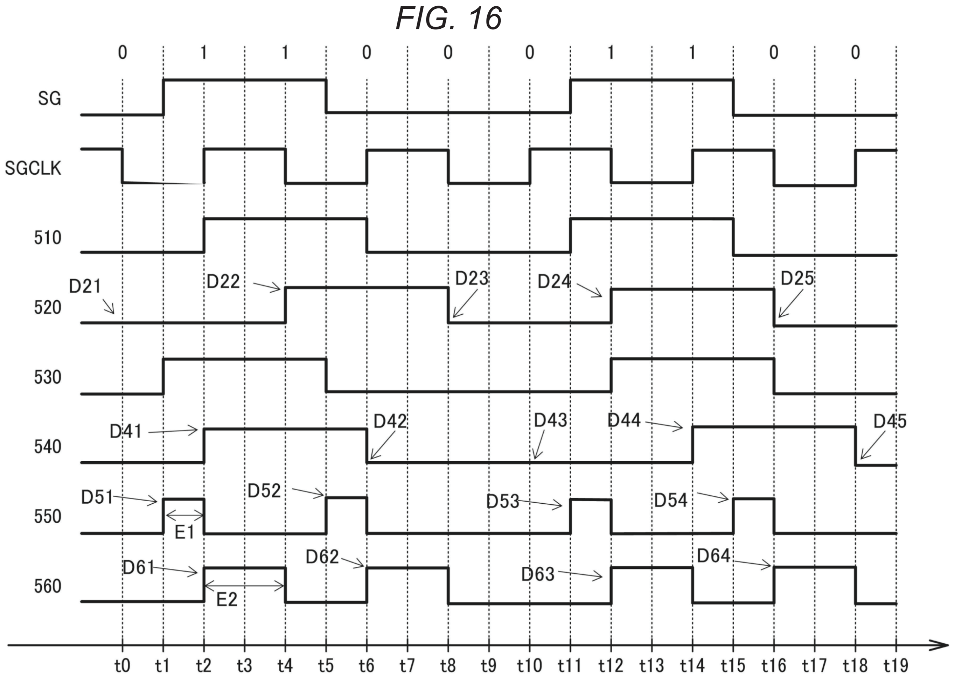

FIG. 16 shows an example of the operation of the phase comparator 500 configured as described above. In FIG. 16, for convenience of description, with time on the horizontal axis, timings t0, t1, t2, t3, t4, t5, t6, t7, t8, t9, t10, t11, t12, t13, t14, t15, t16, t17, t18, and t19 are set at equal intervals on the horizontal axis. For convenience, the interval may be referred to as an interval T. The output waveforms of the input signal SG, the predetermined clock signal SGCLK, the master latch circuit 510, the slave latch circuit 520, the master latch circuit 530, the slave latch circuit 540, the exclusive OR circuit 550, and the exclusive OR circuit 560 are conceptually illustrated in order from the top of FIG. 16. Hereinafter, in order to simplify the description, in the positive signal of the differential signal, a high-level output signal is simply referred to as "1" and a low-level output signal is simply referred to as "0". Furthermore, it is assumed that the input of the input signal SG at a timing before the timing t0 is "0", and the outputs of the master latch circuit 510, the slave latch circuit 520, the master latch circuit 530, and the slave latch circuit 540 are all "0".

The input signal SG illustrated in the example of FIG. 16 is the input signal SG having the locked phase, subjected to the above-described 8b10b conversion or the like, and containing data. For example, from timing t1 to timing t3, "1" is contained as binary data based on the high-level voltage of the input signal SG. That is, in FIG. 16, the input signal SG contains binary data "110001100" at intervals twice the interval T after the timing t1.

At the timing t0, the input signal SG is "0", and the predetermined clock signal SGCLK falls from "1" to "0". Accordingly, the master latch circuit 510 holds the captured input "0" and outputs "0". The slave latch circuit 520 captures "0" as the output from the master latch circuit 510 and outputs "0". The master latch circuit 530 captures "0" as the input of the input signal SG and outputs "0", and the slave latch circuit 540 outputs the held "0". Accordingly, the exclusive OR circuit 550 outputs "0" based on the output "0" of the master latch circuit 510 and the output "0" of the master latch circuit 530. The exclusive OR circuit 560 outputs "0" based on the output "0" of the slave latch circuit 520 and the output "0" of the slave latch circuit 540.

At the timing t1, the input signal SG rises from "0" to "1", and the predetermined clock signal SGCLK is "0". Accordingly, the master latch circuit 510 holds the captured input "0" and outputs "0". The slave latch circuit 520 captures "0" as the output from the master latch circuit 510 and outputs "0". The master latch circuit 530 captures "1" as the input of the input signal SG and outputs "1". The slave latch circuit 540 outputs the held "0". Accordingly, the exclusive OR circuit 550 outputs "1" based on the output "0" of the master latch circuit 510 and the output "1" of the master latch circuit 530. The exclusive OR circuit 560 outputs "0" based on the output "0" of the slave latch circuit 520 and the output "0" of the slave latch circuit 540.

At the timing t2, the input signal SG remains "1", and the predetermined clock signal SGCLK rises from "0" to "1". Accordingly, the master latch circuit 510 captures "1" as the input of the input signal SG. The slave latch circuit 520 holds "0" captured from the master latch circuit 510 and outputs "0". The master latch circuit 530 holds the captured "1" and outputs "1". The slave latch circuit 540 captures "1" as the output of the master latch circuit 530 and outputs "1". Accordingly, at the timing t2, the exclusive OR circuit 550 outputs "0" based on the output "1" of the master latch circuit 510 and the output "1" of the master latch circuit 530. The exclusive OR circuit 560 outputs "1" based on the output "0" of the slave latch circuit 520 and the output "1" of the slave latch circuit 540. Since the operation of the phase comparator 500 at the timing t3 is the same as the operation of the phase comparator 500 at the timing t2, the description thereof will be omitted.

At the timing t4, the input signal SG remains "1", and the predetermined clock signal SGCLK falls from "1" to "0". Accordingly, the master latch circuit 510 holds the captured input "1" and outputs "1". The slave latch circuit 520 captures "1" as the output from the master latch circuit 510 and outputs "1". The master latch circuit 530 captures "1" as the input of the input signal SG and outputs "1", and the slave latch circuit 540 outputs the held "1". Accordingly, at the timing t4, the exclusive OR circuit 550 outputs "0" based on the output "1" of the master latch circuit 510 and the output "1" of the master latch circuit 530. The exclusive OR circuit 560 outputs "0" based on the output "1" of the slave latch circuit 520 and the output "1" of the slave latch circuit 540.

At the timing t5, the input signal SG falls from "1" to "0", and the output of the predetermined clock signal SGCLK is "0". Accordingly, the master latch circuit 510 holds the captured input "1" and outputs "1". The slave latch circuit 520 captures "1" as the output from the master latch circuit 510 and outputs "1". The master latch circuit 530 captures "0" as the input of the input signal SG and outputs "0". The slave latch circuit 540 holds "1" captured from the master latch circuit 530 and outputs "1". Accordingly, the exclusive OR circuit 550 outputs "1" based on the output "1" of the master latch circuit 510 and the output "0" of the master latch circuit 530. The exclusive OR circuit 560 outputs "0" based on the output "1" of the slave latch circuit 520 and the output "1" of the slave latch circuit 540.

At the timing t6, the output of the input signal SG is "0", and the output of the predetermined clock signal SGCLK rises from "0" to "1". Accordingly, the master latch circuit 510 captures "0" as the input from the input signal SG and outputs "0". The slave latch circuit 520 holds "0" captured from the master latch circuit 510. The master latch circuit 530 captures "0" as the input from the input signal SG and outputs "0". The slave latch circuit 540 captures "0" as the output from the master latch circuit 530 and outputs "0". Accordingly, the exclusive OR circuit 550 outputs "0" based on the output "0" of the master latch circuit 510 and the output "0" of the master latch circuit 530. The exclusive OR circuit 560 outputs "1" based on the output "1" of the slave latch circuit 520 and the output "0" of the slave latch circuit 540. Since the operation of the phase comparator 500 at the timing t7 is the same as the operation of the phase comparator 500 at the timing t6, the description thereof will be omitted.

At the timing t8, the output of the input signal SG is "0", and the output of the predetermined clock signal SGCLK falls from "1" to "0". Accordingly, the master latch circuit 510 holds the captured input "0" and outputs "0". The slave latch circuit 520 captures "0" as the output from the master latch circuit 510 and outputs "0". The master latch circuit 530 captures "0" as the input of the input signal SG and outputs "0", and the slave latch circuit 540 holds the captured "0" and outputs "0". Accordingly, at the timing t8, the exclusive OR circuit 550 outputs "0" based on the output "0" of the master latch circuit 510 and the output "0" of the master latch circuit 530. The exclusive OR circuit 560 outputs "0" based on the output "0" of the slave latch circuit 520 and the output "0" of the slave latch circuit 540. Since the operation of the phase comparator 500 at the timing t9 is the same as the operation of the phase comparator 500 at the timing t8, the description thereof will be omitted.

At the timing t10, the output of the input signal SG is "0", and the output of the predetermined clock signal SGCLK rises from "0" to "1". Accordingly, the master latch circuit 510 captures "0" as the input from the input signal SG and outputs "0". The slave latch circuit 520 holds "0" captured from the master latch circuit 510. The master latch circuit 530 captures "0" as the input from the input signal SG and outputs "0". The slave latch circuit 540 captures "0" as the output from the master latch circuit 530 and outputs "0". Accordingly, at the timing t10, the exclusive OR circuit 550 outputs "0" based on the output "0" of the master latch circuit 510 and the output "0" of the master latch circuit 530. The exclusive OR circuit 560 outputs "0" based on the output "0" of the slave latch circuit 520 and the output "0" of the slave latch circuit 540.

At the timing t11, the output of the input signal SG rises from "0" to "1", and the output of the predetermined clock signal SGCLK remains "1". Accordingly, the master latch circuit 510 captures "1" as the input from the input signal SG and outputs "1". The slave latch circuit 520 holds "0" captured from the master latch circuit 510 and outputs "0". The master latch circuit 530 holds the captured "0" and outputs "0". The slave latch circuit 540 captures "0" as the output from the master latch circuit 530 and outputs "0". Accordingly, at the timing t11, the exclusive OR circuit 550 outputs "1" based on the output "1" of the master latch circuit 510 and the output "0" of the master latch circuit 530. The exclusive OR circuit 560 outputs "0" based on the output "0" of the slave latch circuit 520 and the output "0" of the slave latch circuit 540.

At the timing t12, the output of the input signal SG remains "1", and the output of the predetermined clock signal SGCLK falls from "1" to "0". Accordingly, the master latch circuit 510 outputs "1" to hold the captured "1". The slave latch circuit 520 captures "1" as the output from the master latch circuit 510 and outputs "1". The master latch circuit 530 captures "1" as the output of the input signal SG and outputs "1", and the slave latch circuit 540 holds "0" captured from the master latch circuit 530 and outputs "0". Accordingly, at the timing t12, the exclusive OR circuit 550 outputs "0" based on the output "1" of the master latch circuit 510 and the output "1" of the master latch circuit 530. The exclusive OR circuit 560 outputs "1" based on the output "1" of the slave latch circuit 520 and the output "0" of the slave latch circuit 540. Since the operation of the phase comparator 500 at the timing t13 is the same as the operation of the phase comparator 500 at the timing t12, the description thereof will be omitted.

At the timing t14, the output of the input signal SG remains "1", and the output of the predetermined clock signal SGCLK rises from "0" to "1". Accordingly, the master latch circuit 510 captures "1" as the output of the input signal SG and outputs "1". The slave latch circuit 520 holds "1" captured from the master latch circuit 510 and outputs "1". The master latch circuit 530 holds the captured "1" and outputs "1". The slave latch circuit 540 captures "1" as the output of the master latch circuit 530 and outputs "1". Accordingly, at the timing t14, the exclusive OR circuit 550 outputs "0" based on the output "1" of the master latch circuit 510 and the output "1" of the master latch circuit 530. The exclusive OR circuit 560 outputs "0" based on the output "1" of the slave latch circuit 520 and the output "1" of the slave latch circuit 540.

At the timing t15, the output of the input signal SG falls from "1" to "0", and the output of the predetermined clock signal SGCLK remains "1". Accordingly, the master latch circuit 510 captures "0" as the input from the input signal SG and outputs "0". The slave latch circuit 520 holds "1" captured from the master latch circuit 510 and outputs "1". The master latch circuit 530 holds the captured "1" and outputs "1". The slave latch circuit 540 captures "1" as the output from the master latch circuit 530 and outputs "1". Accordingly, at the timing t15, the exclusive OR circuit 550 outputs "1" based on the output "0" of the master latch circuit 510 and the output "1" of the master latch circuit 530. The exclusive OR circuit 560 outputs "0" based on the output "1" of the slave latch circuit 520 and the output "1" of the slave latch circuit 540.

At the timing t16, the output of the input signal SG remains "0", and the output of the predetermined clock signal SGCLK falls from "1" to "0". Accordingly, the master latch circuit 510 holds the captured "0" and outputs "0". The slave latch circuit 520 captures the input "0" from the master latch circuit 510 and outputs "0". The master latch circuit 530 captures "0" as the input of the input signal SG and outputs "0". The slave latch circuit 540 holds "1" captured from the master latch circuit 530 and outputs "1". Accordingly, at the timing t16, the exclusive OR circuit 550 outputs "0" based on the output "0" of the master latch circuit 510 and the output "0" of the master latch circuit 530. The exclusive OR circuit 560 outputs "1" based on the output "0" of the slave latch circuit 520 and the output "1" of the slave latch circuit 540. Since the operation of the phase comparator 500 at the timing t17 is the same as the operation of the phase comparator 500 at the timing t16, the description thereof will be omitted.

At the timing t18, the output of the input signal SG remains "0", and the output of the predetermined clock signal SGCLK rises from "0" to "1". Accordingly, the master latch circuit 510 captures "0" as the output of the input signal SG and outputs "0". The slave latch circuit 520 holds "0" captured from the master latch circuit 510 and outputs "0". The master latch circuit 530 holds the captured "0" and outputs "0". The slave latch circuit 540 captures "0" as the output of the master latch circuit 530 and outputs "0". Accordingly, at the timing t18, the exclusive OR circuit 550 outputs "0" based on the output "0" of the master latch circuit 510 and the output "0" of the master latch circuit 530. The exclusive OR circuit 560 outputs "0" based on the output "0" of the slave latch circuit 520 and the output "0" of the slave latch circuit 540. Since the operation of the phase comparator 500 at the timing t19 is the same as the operation of the phase comparator 500 at the timing t18, the description thereof will be omitted.

When the phase comparator 500 operates as described above, a pulse indicated by D51 in FIG. 16 is output from the exclusive OR circuit 550, and then a pulse indicated by D61 is output from the exclusive OR circuit 560. The pulse indicated by D51 has a pulse width indicated by E1, the pulse indicated by D61 has a pulse width indicated by E2, and the width indicated by E2 is twice the width indicated by E1. The same applies to a relationship between a pulse indicated by D52 and a pulse indicated by D62, the same applies to a relationship between a pulse indicated by D53 and a pulse indicated by D63, and the same applies to a relationship between a pulse indicated by D54 and a pulse indicated by D64. That is, there is a relationship in which, regardless of the waveform of the input signal SG, when a pulse is output from the exclusive OR circuit 550, a pulse having a double pulse width is certainly output from the exclusive OR circuit 560.

It can also be seen from FIG. 16 that a pulse is generated from the exclusive OR circuit 550 when the timing at which the predetermined clock signal SGCLK rises or falls is delayed with respect to the timing at which the input signal SG rises or falls. That is, the pulse generated from the exclusive OR circuit 550 corresponds to the UP signal. Therefore, by making the pulse generated from the exclusive OR circuit 560 correspond to the DOWN signal, the phase comparator 500 can be operated to lock the phase.

That is, the UP signal and the DOWN signal may be output such that the phase is locked in a state in which the phase of the predetermined clock signal SGCLK is delayed by 90 degrees with respect to the input signal SG. However, since the width of the pulse corresponding to the DOWN signal is twice the width of the pulse corresponding to the UP signal, the second charge pump circuit 620 is required to set the current value output based on the UP signal input from the phase comparator 500 to twice the current value output based on the DOWN signal input from the phase comparator 500. Accordingly, the amount of charge related to the source current fed from the second charge pump circuit 620 to the loop filter 200 and the amount of charge related to the sink current drawn from the control voltage node NCV can be made equal to each other, and thus the phase can be locked. As described above, in the synchronizing circuit 10 of the present embodiment, the second charge pump circuit 620 outputs the current based on the UP signal and the current based on the DOWN signal, and the current value based on the UP signal is twice the current value based on the DOWN signal. According to the configuration, when the phase locked loop PLP is operated such that the pulse width of the DOWN signal output from the phase comparator 500 is twice the pulse width of the UP signal, the phase of the input signal SG and the phase of the predetermined clock signal SGCLK can be locked.

The current value of the sink current of the first charge pump circuit 610 based on the UP signal output from the frequency phase comparator 400 is equal to the current value of the sink current of the first charge pump circuit 610 based on the DOWN signal output from the frequency phase comparator 400. Therefore, as described above, the first charge pump circuit 610 and the second charge pump circuit 620 have different specifications. As described above, when the phase comparator 500 is of the half-rate type, it is necessary to form the synchronizing circuit 10 illustrated in FIGS. 2, 3, and 5. In contrast, when the phase comparator 500 is of the Bang-Bang type, since the pulse width related to the UP signal and the pulse width related to the DOWN signal are the same, as shown in FIGS. 7 and 8, the same third charge pump circuit 630 can be used for both the frequency locked loop FLP and the phase locked loop PLP.

The phase comparator 500 may be configured to recover data from the input signal SG. For example, the serial data related to the input signal SG is divided into even-numbered data blocks and odd-numbered data blocks by deserialization processing. For example, a data block related to a timing when the predetermined clock signal SGCLK rises is a first data block as an odd-numbered data block, and a data block related to a timing when the predetermined clock signal SGCLK falls is a second data block as an even-numbered data block. In this case, the outputs of the slave latch circuits 540 indicated by D41, D42, D43, D44, and D45 in FIG. 16 correspond to the data of the first data block. That is, D41 indicates "1", D42 indicates "0", D43 indicates "0", D44 indicates "1", and D45 indicates "0", and the data matches the data of the input signal SG described above. Similarly, the outputs of the slave latch circuit 520 indicated by D21, D22, D23, D24, and D25 in FIG. 16 correspond to the data of the second data block. That is, D21 indicates "0", D22 indicates "1", D23 indicates "0", D24 indicates "1", and D25 indicates "0", and the data matches the data of the input signal SG described above. Therefore, by inputting the output of the slave latch circuit 520 and the output of the slave latch circuit 540 to the output stage of a dotted line frame D10 in FIG. 15, the data of the input signal SG is output from the output stage. As a result, the data of the input signal SG is recovered. That is, the dotted line frame indicated by D10 in FIG. 15 corresponds to the data recovery circuit 50 in FIG. 1. Note that the flip-flop circuit 570 within the dotted line frame D10 in FIG. 15 is disposed to align the input/output timing of the buffer indicated by D11 and the input/output timing of the buffer indicated by D12.

As described above, the synchronizing circuit of the present embodiment includes the voltage-controlled oscillator that generates the predetermined clock signal as the clock signal having the frequency corresponding to the control voltage of the control voltage node, the loop filter coupled to the control voltage node, and the switch circuit that switches between the frequency locked loop and the phase locked loop. The frequency locked loop includes the frequency phase comparator, the loop filter, and the voltage-controlled oscillator, and performs frequency synchronization between the predetermined clock signal and the input signal. The phase locked loop includes the phase comparator, the loop filter, and the voltage-controlled oscillator, and performs phase synchronization between the predetermined clock signal and the input signal. When the frequency locked loop is selected by the switch circuit, the loop filter performs the first loop filter processing as the loop filter processing of the first filter characteristics. When the phase locked loop is selected by the switch circuit, the loop filter performs the second loop filter processing as the loop filter processing of the second filter characteristics different from the first filter characteristics.

According to the configuration, since the different loop filter processing is performed in the frequency locked loop and the phase locked loop, it is possible to more appropriately operate the synchronizing circuit with the single loop filter.

The comparison frequency of the phase locked loop may be higher than the comparison frequency of the frequency locked loop, and the cutoff frequency of the second filter characteristics may be higher than the cutoff frequency of the first filter characteristics.

According to the configuration, it is possible to perform appropriate loop filter processing in each of the frequency locked loop and the phase locked loop.

The synchronizing circuit may further include the first divider that divides the clock signal and the second divider that divides the input signal. The synchronizing circuit may further include the frequency phase comparator that compares the output clock signal of the first divider with the output clock signal of the second divider, the first charge pump circuit that outputs the current according to the comparison result of the frequency phase comparator, and the second charge pump circuit that outputs the current according to the comparison result of the phase comparator. The frequency locked loop may further include the first divider, the second divider, and the first charge pump circuit. The phase locked loop may further include the second charge pump circuit.

According to the configuration, it is possible to construct the frequency locked loop compatible with the rate of the faster input signal and predetermined input clock signal, and it is possible to construct the synchronizing circuit to include the different charge pump circuits for the frequency locked loop and the phase locked loop.

The switch circuit may further include the first switch circuit including the first first-switch coupled between the input node to which the input signal is input and the second divider, and the first second-switch coupled between the input node and the phase comparator. The switch circuit may further include the second switch circuit including the second first-switch coupled between the first charge pump circuit and the control voltage node, and the second second-switch coupled between the second charge pump circuit and the control voltage node. The frequency locked loop may be selected when the first first-switch and the second first-switch are turned on, and the phase locked loop may be selected when the first second-switch and the second second-switch are turned on.

According to the configuration, it is possible to construct the synchronizing circuit that switches between the frequency locked loop and the phase locked loop by on-off control of the first switch circuit and the second switch circuit.

The second charge pump circuit may output the current based on the UP signal and the current based on the DOWN signal, and the current value based on the UP signal may be twice the current value based on the DOWN signal.

According to the configuration, when the phase locked loop is operated such that the pulse width of the DOWN signal output from the phase comparator is twice the pulse width of the UP signal, the phase of the input signal and the phase of the predetermined clock signal can be locked.

The synchronizing circuit may include the third charge pump circuit that outputs the current according to the comparison result of the frequency phase comparator to the control voltage node when the frequency locked loop is selected by the switch circuit, and outputs the current according to the comparison result of the phase comparator to the control voltage node when the phase locked loop is selected by the switch circuit. The frequency locked loop may further include the third charge pump circuit. The phase locked loop may further include the third charge pump circuit.

According to the configuration, since the third charge pump circuit is shared by the frequency locked loop and the phase locked loop, it is possible to construct the simpler synchronizing circuit.

The synchronizing circuit may include the third divider that divides the clock signal and the fourth divider that divides the input signal. The frequency phase comparator may compare the output clock signal of the third divider with the output clock signal of the fourth divider. The frequency locked loop may further include the third divider and the fourth divider.

According to the configuration, it is possible to construct the synchronizing circuit that is compatible with a case where the frequency of the input signal and the frequency of the predetermined clock signal are high and has a simple configuration.

The switch circuit may further include the third switch circuit including the third first-switch coupled between the input node to which the input signal is input and the frequency phase comparator, and the third second-switch coupled between the input node and the phase comparator. The switch circuit may further include the fourth switch circuit including the fourth first-switch coupled between the frequency phase comparator and the charge pump circuit, and the fourth second-switch coupled between the phase comparator and the charge pump circuit. The frequency locked loop may be selected when the third first-switch and the fourth first-switch are turned on, and the phase locked loop may be selected when the third second-switch and the fourth second-switch are turned on.

According to the configuration, it is possible to control the switching between the frequency locked loop and the phase locked loop by turning on and off the third switch circuit and the fourth switch circuit, and construct the synchronizing circuit having the simple configuration.

The loop filter may include the first capacitor having one end coupled to the ground node, the first resistance circuit and the fifth first switch coupled in series between the control voltage node and the other end of the first capacitor, and the second resistance circuit and the fifth second switch coupled in series between the control voltage node and the other end of the first capacitor. The fifth first-switch may be turned on when the frequency locked loop is selected by the switch circuit, and the fifth second-switch may be turned on when the phase locked loop is selected by the switch circuit.

According to the configuration, it is possible to construct the synchronizing circuit including the loop filter including different resistance circuits for the frequency locked loop and the phase locked loop.

The loop filter may further include the second capacitor having one end coupled to the ground node and the other end coupled to the control voltage node.

According to the configuration, it is possible to construct the loop filter as a secondary passive filter.

The synchronizing circuit may further include the control circuit that controls the switch circuit to switch from the frequency locked loop to the phase locked loop, turns off the fifth first-switch from on, and turns the fifth second-switch from off to on when the lock of the frequency locked loop is detected.

According to the configuration, it is possible to electrically on/off-control the execution of the first loop filter processing by the loop filter including the first resistance circuit in the frequency locked loop and the execution of the second loop filter processing by the loop filter including the second resistance circuit in the phase locked loop.

The control circuit may detect whether the frequency of the predetermined clock signal output by the voltage-controlled oscillator is locked to the frequency of the clock signal of the input signal having the predetermined rate in the frequency locked loop. The switch circuit may switch from the frequency locked loop to the phase locked loop when the control circuit detects the lock of the frequency locked loop. The phase locked loop may synchronize the phase of the clock signal of the input signal as the data signal with the phase of the predetermined clock signal output by the voltage-controlled oscillator.

According to the configuration, it is possible to construct the control circuit that controls the switch circuit so as to switch from the frequency locked loop to the phase locked loop after the frequency is locked by the frequency locked loop.

The first resistance circuit and the second resistance circuit may be variable resistance circuits.

According to the configuration, it is possible to make the first filter characteristics and the second filter characteristics different by more combinations.

The present embodiment relates to a communication interface circuit including the above-described synchronizing circuit.

The communication interface circuit may further include the data recovery circuit that recovers data of the input signal based on the predetermined clock signal generated by the phase locked loop.

According to the configuration, it is possible to operate the device provided in the communication interface circuit based on the data of the input signal whose phase is locked by the synchronizing circuit having the above-described effects.

While the present embodiment has been described in detail above, a person skilled in the art could readily understand that many modifications can be made without substantively departing from the novel matters and effects of the present disclosure. Therefore, all such modifications should fall within the scope of the present disclosure. For example, a term described at least once together with a different term having a broader meaning or the same meaning in the specification or the drawings can be replaced with the different term in any part of the specification or the drawings. All combinations of the present embodiment and the modifications also fall within the scope of the present disclosure. The configurations, operations, and the like of the synchronizing circuit, the communication interface circuit, and the like are not limited to those described in the present embodiment, and various modifications can be made.

## Claims

1. A synchronizing circuit comprising:
a voltage-controlled oscillator that generates a predetermined clock signal as a clock signal having a frequency corresponding to a control voltage of a control voltage node;
a loop filter coupled to the control voltage node; and
a switch circuit that switches between a frequency locked loop and a phase locked loop, wherein
the frequency locked loop includes a frequency phase comparator, the loop filter, and the voltage-controlled oscillator, and performs frequency synchronization between the predetermined clock signal and an input signal,
the phase locked loop includes a phase comparator, the loop filter, and the voltage-controlled oscillator, and performs phase synchronization between the predetermined clock signal and the input signal, and
the loop filter performs the first loop filter processing as the loop filter processing of first filter characteristics when the frequency locked loop is selected by the switch circuit, and performs the second loop filter processing as the loop filter processing of second filter characteristics different from the first filter characteristics when the phase locked loop is selected by the switch circuit.

2. The synchronizing circuit according to claim 1, wherein
a comparison frequency of the phase locked loop is higher than a comparison frequency of the frequency locked loop, and
a cutoff frequency of the second filter characteristics is higher than a cutoff frequency of the first filter characteristics.

3. The synchronizing circuit according to claim 1, further comprising:
a first divider that divides the predetermined clock signal;
a second divider that divides the input signal;
the frequency phase comparator that compares an output clock signal of the first divider with an output clock signal of the second divider;
a first charge pump circuit that outputs a current according to a comparison result of the frequency phase comparator; and
a second charge pump circuit that outputs a current according to a comparison result of the phase comparator, wherein
the frequency locked loop further includes the first divider, the second divider, and the first charge pump circuit, and
the phase locked loop further includes the second charge pump circuit.

4. The synchronizing circuit according to claim 3, wherein
the switch circuit includes:
a first switch circuit including a first first-switch coupled between an input node to which the input signal is input and the second divider and a first second-switch coupled between the input node and the phase comparator; and
a second switch circuit including a second first-switch coupled between the first charge pump circuit and the control voltage node and a second second-switch coupled between the second charge pump circuit and the control voltage node,
the frequency locked loop is selected when the first first-switch and the second first-switch are turned on, and
the phase locked loop is selected when the first second-switch and the second second-switch are turned on.

5. The synchronizing circuit according to claim 3, wherein
the second charge pump circuit outputs a current based on an UP signal and a current based on a DOWN signal, and
a current value based on the UP signal is twice the current value based on the DOWN signal.

6. The synchronizing circuit according to claim 1, further comprising a charge pump circuit that outputs a current according to a comparison result of the frequency phase comparator to the control voltage node when the frequency locked loop is selected by the switch circuit, and outputs a current according to a comparison result of the phase comparator to the control voltage node when the phase locked loop is selected by the switch circuit, wherein
the frequency locked loop further includes the charge pump circuit, and
the phase locked loop further includes the charge pump circuit.

7. The synchronizing circuit according to claim 6, further comprising:
a third divider that divides the clock signal; and
a fourth divider that divides the input signal, wherein
the frequency phase comparator compares an output clock signal of the third divider with an output clock signal of the fourth divider, and
the frequency locked loop further includes the third divider and the fourth divider.

8. The synchronizing circuit according to claim 6, wherein
the switch circuit includes:
a third switch circuit including a third first-switch coupled between an input node to which the input signal is input and the frequency phase comparator and a third second-switch coupled between the input node and the phase comparator; and
a fourth switch circuit including a fourth first-switch coupled between the frequency phase comparator and the charge pump circuit and a fourth second-switch coupled between the phase comparator and the charge pump circuit,
the frequency locked loop is selected when the third first-switch and the fourth first-switch are turned on, and
the phase locked loop is selected when the third second-switch and the fourth second-switch are turned on.

9. The synchronizing circuit according to claim 1, wherein
the loop filter includes:
a first capacitor having one end coupled to a ground node;
a first resistance circuit and a fifth first-switch coupled in series between the control voltage node and another end of the first capacitor; and
a second resistance circuit and a fifth second-switch coupled in series between the control voltage node and the other end of the first capacitor,
the fifth first-switch is turned on when the frequency locked loop is selected by the switch circuit, and
the fifth second-switch is turned on when the phase locked loop is selected by the switch circuit.

10. The synchronizing circuit according to claim 9, wherein
the loop filter further includes a second capacitor having one end coupled to the ground node and another end coupled to the control voltage node.

11. The synchronizing circuit according to claim 9, further comprising a control circuit that controls the switch circuit to switch from the frequency locked loop to the phase locked loop, turns the fifth first-switch from on to off, and turns the fifth second-switch from off to on when lock of the frequency locked loop is detected.

12. The synchronizing circuit according to claim 11, wherein
the control circuit detects whether a frequency of the predetermined clock signal output by the voltage-controlled oscillator is locked to a frequency of a clock signal of the input signal having a predetermined rate in the frequency locked loop,
the switch circuit switches from the frequency locked loop to the phase locked loop when the control circuit detects the lock of the frequency locked loop, and
the phase locked loop synchronizes phase of the clock signal of the input signal as a data signal with phase of the predetermined clock signal output by the voltage-controlled oscillator.

13. The synchronizing circuit according to claim 9, wherein
the first resistance circuit and the second resistance circuit are variable resistance circuits.

14. A communication interface circuit comprising the synchronizing circuit according to claim 1.

15. The communication interface circuit according to claim 14, further comprising a data recovery circuit that recovers data of the input signal based on the predetermined clock signal generated by the phase locked loop.
